(19) Europäisches Patentamt
European Patent Office
Office européen des brevets

(11) **EP 3 281 021 B1**

(12) **EUROPÄISCHE PATENTSCHRIFT**

(45) Veröffentlichungstag und Bekanntmachung des Hinweises auf die Patenterteilung:
**17.03.2021  Patentblatt 2021/11**

(21) Anmeldenummer: **16727330.9**

(22) Anmeldetag: **20.05.2016**

(51) Int Cl.:
**G01R 23/16** *(2006.01)*     **H03M 1/12** *(2006.01)*

(86) Internationale Anmeldenummer:
**PCT/EP2016/061402**

(87) Internationale Veröffentlichungsnummer:
**WO 2016/206876 (29.12.2016 Gazette 2016/52)**

(54) **VERFAHREN ZUR ANALYSE EINES SIGNALS SOWIE VORRICHTUNG ZUR DURCHFÜHRUNG DES VERFAHRENS**

METHOD FOR ANALYSING A SIGNAL AND DEVICE FOR CARRYING OUT THE METHOD

PROCÉDÉ DESTINÉ À L'ANALYSE D'UN SIGNAL ET DISPOSITIF DESTINÉ À L'EXÉCUTION DU PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.06.2015  EP 15173342**

(43) Veröffentlichungstag der Anmeldung:
**14.02.2018  Patentblatt 2018/07**

(73) Patentinhaber: **Siemens Energy Global GmbH & Co. KG**
**81739 München (DE)**

(72) Erfinder: **HEMPL, Martin**
**90610 Winkelhaid (DE)**

(56) Entgegenhaltungen:
EP-A1- 1 843 230     DE-B4- 10 392 151
US-A- 4 686 457     US-A1- 2009 231 956

• LYONS R: "How to interpolate in the Time-Domain by Zero-Padding in the Frequency Domain", INTERNET CITATION, 13. Januar 2001 (2001-01-13), XP002281208, Gefunden im Internet: URL:http://www.dspguru.com/howto/tech/zero pad.htm [gefunden am 2004-05-21]

**Beschreibung**

Die Erfindung betrifft ein Verfahren zur Analyse eines Signals sowie eine Vorrichtung zur Durchführung eines solchen Verfahrens.

Für die Analyse von Signalen hinsichtlich ihrer Signalkomponenten kommt häufig die Fourier-Transformation, insbesondere die diskrete oder schnelle Fourier-Transformation zum Einsatz. Dabei wird in der Regel angestrebt, die Frequenzen und Amplituden der einzelnen Signalkomponenten des zu analysierenden Signals möglichst genau bestimmen zu können.

Beispielsweise wird gemäß der US 2009/231956 A1 eine inverse zeitliche und räumliche Fourier-Transformation auf ein geschätztes Frequenz-Wellenzahlspektrum angewandt, um Spurinterpolation von den seismischen Daten zu generieren.

Problematisch kann dies jedoch werden, wenn die Signale nicht ausreichend regelmäßig erfasst werden. In solchen Fällen behilft man sich etwa mit verschiedenen Alias-Korrekturen, um dennoch eine zuverlässige Frequenzanalyse durchführen zu können. Ein solches Verfahren ist etwa in US 2009/0231956 A1 beschrieben.

Bei der Bestimmung der Frequenz besteht generell eine Einschränkung aufgrund des sogenannten Nyquist-Shannon- Abtasttheorems. Gemäß diesem muss ein auf eine maximale Frequenz bandbegrenztes Signal, damit es aus dem zeitdiskreten Signal wieder exakt rekonstruiert werden kann, mit einer Abtastfrequenz abgetastet werden, die größer ist als das Zweifache der Bandbreite.

In der Praxis sind alle Systeme hinsichtlich der möglichen Frequenzauflösung beschränkt. Diese lässt sich zwar durch längere Erfassungszeiten oder durch scheinbar längere Erfassungszeiten, für welche ein Signal mit "Nullen" erweitert wird, was auch unter der Bezeichnung Zero-Padding bekannt ist, verbessern. Der Verbesserung sind jedoch Grenzen gesetzt, insbesondere, da mit dieser in der Regel ein erhöhter Rechenaufwand und/oder längere Messzeiten verbunden sind.

Ein weiteres Problem besteht darin, dass aufgrund des sogenannten Leck-Effektes Amplitude und/oder Frequenz einer in einem Signal enthaltenen sinusförmigen Signalkomponente vielfach nicht korrekt wiedergegeben werden können. Dies ist darauf zurückzuführen, dass immer ein endlicher Beobachtungszeitraum gegeben ist und das Signal in der Realität grundsätzlich einen Anfangs- und einen Endzeitpunkt aufweist, was dazu führt, dass in einem via Fourier-Analyse ermittelten Spektrum Frequenzanteile auftauchen, die bei einem nicht realisierbaren unendlich langen Beobachtungzeitraum nicht zu finden wären.

Der Leck-Effekt führt dazu, dass Amplitude und Frequenz sinusförmiger Signalkomponenten nur dann korrekt wiedergegeben werden, wenn die Frequenz genau auf einer der Frequenzlinien des Spektrums liegt. In allen anderen Fällen tritt eine Verbreiterung der die Signalkomponente repräsentieren Peaks und eine Verringerung der Amplitude auf.

Durch den Einsatz unterschiedlicher Fensterfunktionen soll der Leck-Effekt reduziert und die Amplitudengenauigkeit bei allen Frequenzanteilen erhöht werden. Fensterfunktionen sind Funktionen, die außerhalb eines vorgegebenen Intervalls den Wert null haben. Ein zu analysierendes Signal wird mit der Fensterfunktion multipliziert, so dass es außerhalb des vorgegebenen Intervalls ebenfalls den Wert null annimmt. Anschließend wird die Fourier-Transformation durchgeführt.

Um die Frequenz- und Amplitudengenauigkeit zu verbessern, sind aus dem Stand der Technik verschiedene Vorgehensweisen bekannt. Es wird beispielsweise ein Peak-Fitting durch Parabel-, Gauss- oder Lorentz-Kurven durchgeführt.

Das Peak-Fitting mit derartigen Kurven ist dabei in der Praxis teilweise unbefriedigend, da die optimale Kurvenform von der für die Berechnung der Spektren benutzten Fensterfunktion abhängt. Es gibt ferner eine Reihe von Fensterfunktionen, beispielsweise das sogenannte Tukey-Fenster, für die sich gegebenenfalls keine optimale Kurvenform für das Fitting finden lässt.

Ein weiteres Problem kann durch in dem Signal enthaltenes Rauschen oder durch Signalgemische gegeben sein. Mittels Peak-Fitting kann die Frequenz und/oder Amplitude einer in dem Signal enthaltenen sinusförmigen Komponente dann nur vergleichsweise ungenau bestimmt werden.

Ausgehend von dem vorgenannten Stand der Technik ist es daher eine Aufgabe der vorliegenden Erfindung, ein Verfahren der eingangs genannten Art anzugeben, welches eine genauere Signalanalyse bei gleichzeitig möglichst geringem Rechenaufwand ermöglicht, sowie eine Vorrichtung zur Durchführung eines solchen Verfahrens.

Diese Aufgabe wird erfindungsgemäß gelöst durch ein Verfahren zur Analyse eines Signals, bei dem

- ein Spektrum des zu analysierenden Signals bereitgestellt wird, welches das Ergebnis einer Multiplikation des zu analysierenden Signals mit einer vorgegebenen Fensterfunktion und anschließenden insbesondere diskreten oder schnellen Fourier-Transformation ist,

- in dem Spektrum im Bereich zumindest eines peakförmigen lokalen Maximums die bezüglich ihrer Amplitude höchste Spektrallinie und die zu dieser unmittelbar benachbarte, bezüglich ihrer Amplitude zweithöchste Spektrallinie des lokalen Maximums ermittelt wird,

- die Amplitude der höchsten Spektrallinie und die Amplitude der zu dieser benachbarten zweithöchsten Spektrallinie bestimmt wird,

- wenigstens ein von der Amplitude der höchsten Spektrallinie und der Amplitude der zweithöchsten Spektrallinie abhängiger Wert, insbesondere das Verhältnis der Amplitude der höchsten Spektrallinie zu der Amplitude der zweithöchsten Spektrallinie und/oder das Verhältnis der Amplitude der höchsten Spektrallinie zu dem Mittelwert aus den Amplituden der höchsten und der zweithöchsten Spektrallinie ermittelt wird,

- aus dem ermittelten Wert, insbesondere Verhältnis unter Heranziehung einer Frequenz-Korrektur-Kennlinie, welche für die vorgegebene Fensterfunktion erstellt wurde, ein Frequenz-Korrekturwert für die Frequenz der höchsten Spektrallinie ermittelt wird, und

- die Frequenz der höchsten Spektrallinie um den Frequenz-Korrekturwert korrigiert wird.

Der Erfindung liegt mit anderen Worten die Idee zugrunde, die Frequenz einer oder mehrerer in einem Signal enthaltenen Komponenten zu korrigeren bzw. die Schätzung der Frequenz der Komponente(n) zu verbessern, wobei auf eine Kennlinie für die zum Einsatz kommende Fensterfunktion zurückgegriffen wird.Konkret wird erfindungsgemäß aus dem Spektrum des Signals ein Wert ermittelt, welcher von der Amplitude der höchsten und der zweithöchsten Spektrallinie im Bereich eines lokalen Maximums, also eines Peaks, welcher einer Komponente des Signals entspricht, bestimmt. Aus dem erhaltenen Wert und unter Heranziehung einer Frequenz-Korrektur-Kennlinie wird die Frequenz der höchsten Spektrallinie korrigiert.

Bei dem betrachteten zu analysierenden Signal kann es sich beispielsweise um ein äquidistant zeitabhängiges oder ein äquidistant winkelabhängiges Signal handeln. Demgemäß kann, um das Spektrum des Signals zu erhalten, eine Frequenz-Analyse oder eine Ordnungs-Analyse durchgeführt werden bzw. durchgeführt worden sein.

Im Rahmen der Frequenz-Analyse wird die Fourier-Transformation eines äquidistant zeitabhängigen Signals durchgeführt und diese liefert Frequenzen im Zeitbereich, so dass Informationen über die Anzahl von Schwingungen pro Zeiteinheit erhalten werden.

Die Ordnungsanalyse, im Rahmen derer ein äquidistant winkelabhängiges Signal Fourier-transformiert wird, liefert Frequenzen im Winkelbereich, welche auch als Ordnungen bezeichnet werden. Die Ordnungsanalyse findet insbesondere im Rahmen der Schwingungsanalyse rotierender Maschinen statt, wobei das Signal dann in Abhängigkeit des Drehwinkels der Maschine verarbeitet wird. Es werden z.B. Signale alle 360/16 Grad verarbeitet.

Im Rahmen des erfindungsgemäßen Verfahrens kommt eine Frequenz-Korrektur-Kennlinie zum Einsatz, die spezifisch für die verwendete Fensterfunktion ist.

Dabei kann insbesondere eine Frequenz-Korrektur-Kennlinie herangezogen werden, welche für die vorgegebene Fensterfunktion unter Verwendung von zwei oder mehr insbesondere sinusförmigen Referenzsignalen unterschiedlicher Frequenz erstellt wurde.

Bei dem ermittelten, von der Amplitude der höchsten und der zweithöchsten Spektrallinie abhängigen Wert kann es sich insbesondere um das Verhältnis der Amplitude der höchsten Spektrallinie zu der Amplitude der zweithöchsten Spektrallinie und/oder das Verhältnis der Amplitude der höchsten Spektrallinie zu dem Mittelwert aus den Amplituden der höchsten und der zweithöchsten Spektrallinie handeln. Es ist auch möglich, andere von der Amplitude der höchsten und der zweithöchsten Spektrallinie abhängige Werte zu betrachten.

Die im Rahmen der Durchführung des Verfahrens erfindungsgemäß herangezogene Frequenz-Korrektur-Kennlinie für die vorgegebene Fensterfunktion wird beispielsweise erstellt, indem

- zwei oder mehr insbesondere sinusförmige Referenzsignale bereitgestellt werden,

- jedes Referenzsignal mit der Fensterfunktion multipliziert wird,

- jedes mit der Fensterfunktion multiplizierte Referenzsignal einer insbesondere diskreten oder schnellen Fourier-Transformation unterworfen werden,

- aus jedem transformierten Spektrum im Bereich eines lokalen Maximums jeweils die höchste Spektrallinie und die zu dieser unmittelbar benachbarte zweithöchste Spektrallinie ermittelt wird,

- für jedes transformierte Spektrum die Amplitude der höchsten Spektrallinie und die Amplitude der zweithöchsten Spektrallinie ermittelt wird,

- für jedes transformierte Spektrum wenigstens ein von der Amplitude der höchsten Spektrallinie und der Amplitude der zweithöchsten Spektrallinie abhängiger Wert, insbesondere das Verhältnis der Amplitude der höchsten Spektrallinie zu der Amplitude der zweithöchsten Spektrallinie und/oder das Verhältnis der Amplitude der höchsten Spektrallinie zu dem Mittelwert aus den Amplituden der höchsten und der zweithöchsten Spektrallinie ermittelt wird,

- die ermittelten Werte, insbesondere Verhältnisse zusammen mit der zugehörigen Frequenz der Referenzsignale als Wertepaare abgelegt werden, und

- auf Basis der Wertepaare eine Kennlinie erstellt wird.

Bei dem wenigstens einen von der Amplitude der höchsten Spektrallinie und der Amplitude der zweithöchsten Spektrallinie abhängigen Wert, welcher im Rahmen der Erstellung der Frequenz-Korrektur-Kennlinie aus den Referenzspektren ermittelt wird, handelt es sich zweckmäßiger Weise um denjenigen wenigstens einen Wert, welcher in dem Spektrum des zu analysierenden Signals für die erfindungsgemäße Frequenzkorrektur ermittelt wird. Beispielsweis wird, wenn im Rahmen des erfindungsgemäßen Verfahrens aus dem Spektrum des zu analysierenden Signals das Verhältnis der Amplitude der höchsten Spektrallinie zu dem Mittelwert aus den Amplituden der höchsten und der zweithöchsten Spektrallinie bestimmt wird, zweckmäßiger Weise eine Frequenz-Korrekturkennlinie herangezogen, im Rahmen deren Erstellung ebenfalls das Verhältnis der Amplitude der höchsten Spektrallinie zu dem Mittelwert aus den Amplituden der höchsten und der zweithöchsten Spektrallinie aus den Referenzspektren ermittelt wurde.

Ferner kann vorgesehen sein, dass mehrere Referenzsignale bereitgestellt werden, indem

- ein insbesondere sinusförmiges Referenzsignal bekannter Frequenz bereitgestellt wird,

- das Referenzsignal zwischen der Frequenz einer beliebigen Spektrallinie $f_{LinieL}$ und der Frequenz einer zu dieser benachbarten Spektrallinie variiert wird, um N weitere Referenzsignale mit den Frequenzen

$$f_n \ = \ f_{LinieL} \ + \ n/N \ * \ \Delta f$$

mit n = 0 ... N und der Auflösung $\Delta f$ zu erhalten.

Es kann ferner vorgesehen sein, dass die aus den Spektren der Referenzsignale ermittelten von der Amplitude der höchsten Spektrallinie und der Amplitude der zweithöchsten Spektrallinie abhängigen Werte, insbesondere Verhältnisse der Amplitude der höchsten Spektrallinie zu der Amplitude der zweihöchsten Spektrallinie oder die Verhältnisse der Amplitude der höchsten Spektrallinie zu dem Mittelwert aus den Amplituden der höchsten und der zweithöchsten Spektrallinie in einem Graphen gegen die variierte Frequenz oder gegen das Verhältnis n/N oder gegen den Offset der Frequenzen n/N*$\Delta f$ aufgetragen werden.

An die in dem Graphen dargestellten Werte wird dann beispielsweise wenigstens eine Fit-Funktion angelegt, insbesondere wenigstens eine lineare Fit-Funktion, und es kann bevorzugt die wenigstens eine Fit-Funktion als Frequenz-Korrektur-Kennlinie herangezogen werden.

Eine lineare Fit-Funktion ist insbesondere dann zweckmäßig, wenn als Wert, welcher von der Amplitude der höchsten und der unmittelbar benachbarten zweithöchsten Spektrallinie abhängt, das Verhältnis der Amplitude der höchsten Spektrallinie zu dem Mittelwert aus den Amplituden der höchsten und der zweithöchsten Spektrallinie betrachtet wird.

Eine für eine Fensterfunktion spezifische Frequenz-Korrektur-Kennlinie kann auf besonders geeignete Weise erstellt werden, indem mehrere insbesondere sinusförmige Referenzsignale herangezogen werden, die unterschiedliche Frequenzen aufweisen.

Ist der Zusammenhang zwischen den Amplituden-Verhältnissen von höchster und zweithöchster Spektrallinie und der Frequenz nahezu linear bzw. linear, reichen im einfachsten Falle zwei Referenzsignale aus, um eine Kennlinie zu erhalten. Beispielsweise kann dann aus den beiden zugehörigen transformierten Spektren jeweils das Amplituden-Verhältnis ermittelt und jeweils zusammen mit der Frequenz des Referenzsignales, aus dessen Spektrum das Verhältnis ermittelt wurde, als Wertepaar abgelegt werden. Es kann dann beispielsweise eine Kennlinie erstellt werden, indem eine lineare Fit-Funktion durch die beiden Wertepaare gelegt wird, um weitere Wertepaare von Amplituden-Verhältnissen und Frequenzen zu erhalten, welche für eine verbesserte Frequenzbestimmung eines zu analysierenden Signales herangezogen werden können.

Insbesondere, um die Genauigkeit zu erhöhen, können auch mehre als zwei Referenzsignale für die Erstellung einer Frequenz-Korrektur-Kennlinie für eine bestimmte Fensterfunktion zu erstellen. Auch für den Fall, dass eine Fensterfunktion zum Einsatz kommt, für welche unbekannt ist, wie sich das Amplitudenverhältnis mit der Frequenz ändert, werden zweckmäßigerweise mehr als zwei Wertepaare ermittelt, um das Verhalten ermittelt zu können.

Mehrere Referenzsignale unterschiedlicher Frequenz können beispielsweise bereitgestellt werden, indem ein Referenzsignal bekannter Frequenz vorgegeben wird und das Referenzsignal zwischen der Frequenz einer beliebigen Spektrallinie $f_{LinieL}$ aus seinem transformierten Spektrum und der Frequenz einer zu dieser Spektrallinie benachbarten Spektrallinie $f_{LinieL+1}$ variiert wird, um N weitere Referenzsignale mit den Frequenzen $f_n = f_{LinieL} + n/N * \Delta f$ mit n = 0 ... N und der Auflösung $\Delta f$ zu erhalten.

Das Referenzsignal kann beispielsweise in N = 10 Schritten, insbesondere in N = 20 Schritten, bevorzugt in N = 50 Schritten, besonders bevorzugt in N = 100 Schritten variiert werden.

Erfolgt eine Variation in N = 10 Schritten, entspricht n = 0 genau der Frequenz der ersten Spektrallinie, n = 10 der Frequenz der darauffolgenden Spektrallinie und n = 5 der Mitte zwischen den beiden Linien. In gleicher Weise entspricht bei einer Variation in N = 100 Schritten n = 0 der Frequenz der ersten, n = 100 der Frequenz der darauffolgenden Linie und n = 50 der Mitte zwischen den beiden Spektrallinien.

Für jeder der Frequenzen $f_n$ wird das Referenzsignal mit der vorgegebenen Fensterfunktion, für welche die Frequenz-Korrektur-Kennlinie erfindungsgemäß zu erstellen ist, multipliziert und das erhaltene Signal wird Fourier-Transformiert, insbesondere einer schnellen oder diskreten Fourier-Transformation unterworfen. Für jede der Frequenzen $f_n$ werden in dem jeweiligen transformierten Spektrum die höchste und die zweithöchste Linie im Bereich wenigstens einen lokalen Maximums ermittelt. Weist das Spektrum des Referenzsignals nur ein eine Signalkomponente repräsentierendes lokales Maximum auf, wird dieses betrachtet.

Im Bereich des lokalen Maximums wird jeweils die Amplitude der höchsten und zu dieser unmittelbar benachbarten zweithöchsten Linie bestimmt. Es wird das Verhältnis der Amplituden der höchsten und zweithöchsten Spektrallinie und/oder das Verhältnis der Amplitude der höchsten zu dem Mittelwert aus den beiden Spektrallinie gebildet.

Die Verhältnisse werden zusammen mit den zugehörigen Frequenzen als Wertepaare abgelegt und es wird eine Kennlinie aus den Wertepaaren erstellt.

Die erhaltenen Verhältnisse können zum Beispiel in einen Graphen, beispielsweise über die variierte Frequenz oder das Verhältnis n/N oder den Offset der Frequenzen n/N*$\Delta$f, eingetragen werden.

Die Punkte bei n = 0 und n = N/2 sind charakteristisch für die verwendete Fensterfunktion.

Die Werte der Frequenz-Korrektur-Kennlinie sind in der Regel symmetrisch zu der mittleren Frequenz n = N/2. Für eine Hamming-Fensterfunktion beispielsweise liegen die Werte der Amplituden-Verhältnisse auf zwei Geraden, die symmetrisch um n = N/2 sind, wenn als der von den Amplituden der höchsten und zweithöchsten Spektrallinie abhängiger Wert das Verhältnis der Amplitude der höchsten Spektrallinie zu dem Mittelwert aus den Amplituden von höchster und zweithöchster Spektrallinie betrachtet wird.

Um für die Frequenz-Korrektur aus einem Amplituden-Verhältnis, welches aus einem zu analysierenden Signal ermittelt wurde, auf besonders komfortable Weise eine Frequenz-Verschiebung zu schließen, die erfindungsgemäß korrigiert wird, kann die Fit-Funktion bzw. können die Fit-Funktionen einfach umgestellt werden, beispielweise von dem Amplituden-Verhältnis über n/N auf n/N über das Amplituden-Verhältnis. In diesem Falle kann dann auch die umgestellte Fit-Funktion als Frequenz-Korrektur-Kennlinie dienen.

Es hat sich als besonders geeignet erwiesen, ein sinusförmiges Referenzsignal für die erfindungsgemäße Erstellung einer fensterspezifischen Kennlinie zu verwenden. Da ein Signal mit einer Signalkomponente ausreichend ist, kommt ein reines sinusförmiges Signal der Form f(t) = a * sin($\omega$*t + $\varphi$) als Referenzsignal besonders in Frage. Referenzsignale eines anderen zeitlichen Verlaufes sind ebenfalls möglich. Damit ein Signal als Referenz geeignet ist, sollte es sich durch wenigstens ein eine Signalkomponente repräsentierendes lokales Maximum im Spektrum auszeichnen, welches sauber von ggf. vorhandenen benachbarten Komponenten getrennt ist. Ein zeitabhängiges Rechtecksignal kann beispielsweise ebenfalls verwendet werden, sofern diese Bedingung erfüllt ist. Vorteile gegenüber einem sinusförmigen Referenzsignal liegen jedoch keine vor.

Es hat sich herausgestellt, dass sich das Verhältnis der Amplitude der höchsten Spektrallinie zu derjenigen der zweithöchsten bzw. zu dem Mittelwert aus den beiden Amplituden in dem transformierten Spektrum für zahlreiche Fensterfunktionen auf eine bestimmte Weise in Abhängigkeit der Frequenz ändert. Beispielsweise liegt für eine Hamming-Fensterfunktion ein nahezu linearer Zusammenhang zwischen den vorgenannten Verhältnissen der Amplituden und der Frequenz vor. Diese Erkenntnis wird erfindungsgemäß für eine genauere Bestimmung der Frequenz von Signalkomponenten eines zu analysierenden Signals genutzt, indem der Einfluss der Fensterfunktion nachträglich herausgerechnet wird. Dies wird durch die erfindungsgemäße Heranziehung der für die verwendete Fensterfunktion spezifischen Frequenz-Korrektur-Kennlinie möglich, welchen den Zusammenhang zwischen der Änderung der Amplituden-Verhältnisse in Abhängigkeit der Frequenz enthält.

Konkret kann über eine erfindungsgemäß für die Fensterfunktion erstellte Kennlinie aus einem der vorgenannten Verhältnisse der Amplituden der höchsten und zweithöchsten Spektrallinie, welches für ein zu analysierenden Signal bestimmt wurde, auf den Frequenz-Offset, also den Offset der tatsächlichen Frequenz der betrachteten Signalkomponente zu der im Spektrum dargestellten höchsten Spektrallinie, geschlossen werden und es kann eine Korrektur der Frequenz der höchsten Spektrallinie um den Offset erfolgen.

Als Fensterfunktion wird beispielsweise eine Hamming-Fensterfunktion oder eine Tukey-Fensterfunktion oder eine Hanning-Fensterfunktion oder eine Rechteck-Fensterfunktion verwendet. Andere Fensterfunktionen als die hier rein beispielhaft genannten können ebenfalls zum Einsatz kommen.

Für eine vorgegebene Fensterfunktion kann eine spezifische Frequenz-Korrektur-Kennlinie einmalig erstellt werden, auf welche dann für die Frequenz-Korrektur von Signalen zurückgegriffen werden kann, die im Rahmen der Analyse mit genau dieser Fensterfunktion multipliziert werden. Kommt eine Fensterfunktion einer bestimmten Form erstmalig zum Einsatz, wird die Frequenz-Korrektur-Kennlinie vorab erstellt und dann für die Korrektur verwendet.

Unter Anwendung des erfindungsgemäßen Verfahrens kann die Frequenz wenigstens einer Signalkomponente eines Signals mit geringem Aufwand besonders zuverlässig korrigiert werden. Eine Anpassung an unterschiedliche Fensterfunktionen kann dabei unter geringem Aufwand erfolgen, wobei lediglich auf die jeweils für die Fensterfunktion spezifische Frequenz-Korrektur-Kennlinie zurückgegriffen werden muss. Bestehende Ergebnisse einer herkömmlichen Spektren-Berechnung können direkt als Eingangs-Spektrum für das erfindungsgemäße Verfahren verwendet werden. Der mit der Durchführung des Verfahrens verbundene Rechenaufwand ist dabei vergleichsweise gering.

Bei den zu analysierenden, insbesondere zeitanhängig erfassten Signalen kann es sich beispielsweise um Druck- oder Schwingungssignale handeln, die im Rahmen von Condition-Monitoring-Verfahren zur Überwachung einer Anlage, wie etwa einer Gasturbine, erfasst werden. Die Signalkomponenten derartiger Signale sind von besonderem Interesse, wobei eine genauere Bestimmung der Frequenz gemäß der vorliegenden Erfindung die Überwachung einer Anlage verbessern kann.

Die unter Anwendung des erfindungsgemäßen Verfahrens aufbereiteten Frequenzwerte können beispielsweise zur Information über den Zustand der Anlage, insbesondere Gasturbine, zur Ableitung von Meldungen oder zur Rückwirkung auf den Betrieb der Anlage herangezogen werden.

Das erfindungsgemäße Verfahren kann durchgeführt werden, um die Frequenz einer oder auch mehrerer Signalkomponenten eines zu analysierenden Signals zu korrigieren bzw. die Schätzung der Frequenz der Komponente zu verbessern.

So zeichnet sich eine Ausführungsform des erfindungsgemäßen Verfahrens dadurch aus, dass

- in dem Spektrum im Bereich mehrerer lokaler Maxima, insbesondere im Bereich aller lokaler Maxima jeweils die höchste Spektrallinie und die zu dieser unmittelbar benachbarte zweithöchste Spektrallinie ermittelt wird,

- für jedes lokale Maximum die Amplitude der höchsten Spektrallinie und die Amplitude der zweithöchsten Spektrallinie bestimmt wird,

- für jedes lokale Maximum wenigstens ein von der Amplitude der höchsten Spektrallinie und der Amplitude der zweithöchsten Spektrallinie abhängiger Wert, insbesondere das Verhältnis der Amplitude der höchsten Spektrallinie zu der Amplitude der zweithöchsten Spektrallinie und/oder das Verhältnis der Amplitude der höchsten Spektrallinie zu dem Mittelwert aus den Amplituden der höchsten und der zweithöchsten Spektrallinie berechnet wird,

- für jedes lokale Maximum aus dem berechneten Wert, insbesondere Verhältnis unter Heranziehung der Frequenz-Korrektur-Kennlinie ein Frequenz-Korrekturwert für die Frequenz der höchsten Spektrallinie ermittelt wird, und

- für jedes lokale Maximum die Frequenz der höchsten Spektrallinie um den jeweiligen Frequenz-Korrekturwert korrigiert wird.

Weist das Signal mehrere Signalkomponenten auf, die ausreichend weit in dem Spektrum auseinander liegen, sich insbesondere nicht überlagern, kann das erfindungsgemäße Verfahren auch angewendet werden, um die Frequenzen mehrerer, insbesondere aller Signalkomponenten des Signals hinsichtlich ihrer Frequenz zu korrigieren. Ein ausreichender Abstand der Komponenten im Spektrum hängt dabei u.a. von der verwendeten Fensterfunktion und den Ansprüchen an die Genauigkeit ab.

Um die Frequenz mehrerer Komponenten in einem zu analysierenden Signal zu korrigieren, werden in dem transformierten Spektrum des Signals mehrere lokale Maxima getrennt voneinander betrachtet. Konkret werden diejenigen lokalen Maxima in Erwägung gezogen, welche Signalkomponenten repräsentieren, die für die Analyse von Interesse sind. Dabei kann es sich zwei oder mehr, insbesondere auch um alle Signalkomponenten eines Signales handeln. Für jedes der betrachteten lokalen Maxima werden auf die erfindungsgemäße Weise die Amplitude von der höchsten und der unmittelbar benachbarten zweithöchsten Spektrallinie ermittelt und es wird eine von den Amplituden abhängiger Wert, insbesondere eines der vorgenannten Verhältnisse gebildet. Es wird für jedes betrachtete lokale Maximum und somit jede Signalkomponente, die von Interesse ist, erfindungsgemäß ein Korrekturwert ermittelt und die Frequenz der höchsten Linie jedes betrachteten Maximums wird korrigiert.

**EP 3 281 021 B1**

Ist die Frequenz der höchsten Spektrallinie auf die erfindungsgemäße Weise im Bereich zumindest eines lokalen Maximums korrigiert worden, kann in einem nächsten Schritt erfindungsgemäß die Amplitude dieser Linie korrigiert werden.

So ist in Weiterbildung des erfindungsgemäßen Verfahrens vorgesehen, dass aus dem Frequenz-Korrekturwert oder der korrigierten Frequenz für die höchste Spektrallinie im Bereich des wenigstens einen lokalen Maximums aus dem zu analysierenden Signal unter Heranziehung einer Amplituden-Korrektur-Kennlinie, welche insbesondere für die vorgegebene Fensterfunktion unter Verwendung von zwei oder mehr Referenzsignalen unterschiedlicher Frequenz erstellt wurde, ein Amplituden-Korrekturwert und/oder eine korrigierte Amplitude ermittelt wird.

Eine Amplituden-Korrektur-Kennlinie kann beispielsweise erstellt werden, indem aus dem Spektrum jedes Referenzsignals das Verhältnis eines vorgegebenen Sollwertes für die Amplitude der höchsten Spektrallinie zu dem Mittelwert aus den Amplituden der höchsten und der zweithöchsten Spektrallinie ermittelt wird, und die ermittelten Verhältnisse zusammen mit der zugehörigen Frequenz der Referenzsignale als Wertepaare abgelegt werden, und auf Basis der Wertepaare eine Kennlinie erstellt wird.

Für die Erstellung der Amplituden-Korrektur-Kennlinie können in zweckmäßiger Ausgestaltung die Spektren derjenigen Referenzsignale herangezogen werden, auf Basis derer bereits die Frequenz-Korrektur-Kennlinie erfindungsgemäß erstellt wurde.

Die aus den Spektren der Referenzsignale ermittelten Verhältnisse von Sollwert zu Mittelwert können ferner in einem Graphen gegen die variierte Frequenz oder gegen das Verhältnis n/N oder gegen den Offset der Frequenzen n/N*Δf aufgetragen werden und an die in dem Graphen dargestellten Werte kann eine Fit-Funktion angelegt werden. Bei der Fit-Funktion kann es sich insbesondere um eine Polynom-Fit-Funktion zweiten Grades handeln. Es kann ferner vorgesehen sein, dass die Fit-Funktion als Amplituden-Korrekturfunktion verwendet wird.

Die erfindungsgemäße Amplitudenkorrektur kann, genau wie die erfindungsgemäße Korrektur der Frequenz, für nur eine Signalkomponente eines zu analysierenden Signals oder auch für mehrere, insbesondere alle Signalkomponenten eines zu analysierenden Signals durchgeführt werden, wobei dann - völlig analog zu der Vorgehensweise bei der Frequenz-Korrektur - für jedes der betrachteten lokalen Maxima jeweils die Amplitude der höchsten Spektrallinie korrigiert wird, nachdem deren Frequenz korrigiert wurde.

Eine weitere Ausführungsform des erfindungsgemäßen Verfahrens zeichnet sich ferner dadurch aus, dass aus den Spektren der Referenzsignale jeweils im Bereich desjenigen lokalen Maximums, in welchem die höchste und die zweithöchste Spektrallinie ermittelt wurde, die zu der höchsten Spektrallinie unmittelbar benachbarte dritthöchste Spektrallinie und deren Amplitude ermittelt wird, und der Abstand der Amplitude der zweithöchsten Spektrallinie zu der Amplitude der dritthöchsten Spektrallinie ermittelt wird.

Es kann dann weiterhin vorgesehen sein, dass die aus den Spektren der Referenzsignale ermittelten Abstände in einem Graphen gegen die variierte Frequenz oder gegen das Verhältnis n/N oder gegen den Offset der Frequenz n/N*Δf aufgetragen werden, und an die in dem Graphen dargestellten Werte wenigstens eine insbesondere lineare Fit-Funktion angelegt wird und bevorzugt die Fit-Funktion als weitere Amplituden-Korrektur-Kennlinie verwendet wird.

Dann kann in dem Spektrum des zu analysierenden Signals im Bereich desjenigen lokalen Maximums, in welchem die höchste und die zweithöchste Spektrallinie ermittelt wurde, die zu der höchsten Spektrallinie unmittelbar benachbarte dritthöchste Spektrallinie und deren Amplitude ermittelt werden, und der Abstand der Amplitude der zweithöchsten Spektrallinie von der Amplitude der dritthöchsten Spektrallinie als Abstands-Istwert, bezogen auf eine zum Beispiel auf 1 normierte Amplitude der höchsten Spektrallinie, ermittelt werden.

Aus der Fit-Funktion für die aus den Spektren der Referenzsignale ermittelten Abstände kann beispielsweise ein Abstands-Sollwert für den Abstand von der Amplitude der zweithöchsten Spektrallinie zu der Amplitude der dritthöchsten Spektrallinie ermittelt werden und dieser kann mit dem Abstands-Istwert verglichen werden.

Dabei kann vorgesehen sein, dass der Amplituden-Korrekturwert und/oder die korrigierte Amplitude in dem Maße reduziert werden, indem der Abstands-Istwert von dem Abstands-Sollwert abweicht.

Es kann ferner das Verhältnis aus dem reduzierten Amplituden-Korrekturwert zu dem Amplituden-Korrekturwert und/oder das Verhältnis aus der reduzierten korrigierten Amplitude zu der korrigierten Amplitude gebildet und als Qualitätskriterium berücksichtigt werden.

Ist das zu analysierende Signal beispielsweise nicht sinusförmig bzw. weist Frequenzkomponenten auf, die nahe beieinander liegen oder enthält Rauschenoder Messfehler, kann es zweckmäßig sein, im Rahmen des erfindungsgemäßen Verfahrens die Korrektur der Amplitude des bzw. der höchsten Spektrallinien weiter zu korrigieren, um kontinuierlich sinnvolle Werte sowohl für sehr gut als auch für sehr wenig den dem erfindungsgemäßen Verfahren zugrunde liegenden Annahmen entsprechenden Signale zu erhalten. Signalamplituden, die den Annahmen nicht entsprechen, z.B. reines Rauschen, werden durch das Verfahren nicht erhöht.

Dabei wird dem Umstand Rechnung getragen, dass die von den Amplituden abhängenden Werte, insbesondere die Verhältnisse der Amplituden der Spektrallinien in dem Spektrum eines zu analysierenden Signals mit überlagerten weiteren Signalkomponenten Abweichungen gegenüber den Spektren der Referenzsignale aufweisen.

Für eine erfindungsgemäße weitere Korrektur kann beispielweise zusätzlich die Amplitude der dritthöchsten Spektrallinie herangezogen werden. Dabei wird erfindungsgemäß aus dem Spektrum des zu analysierenden Signals der Abstand der Amplitude der zweithöchsten Spektrallinie zu der Amplitude der dritthöchsten Spektrallinie als Istwert ermittelt und dieser Abstand wird mit einem theoretischen Wert, konkret mit einem Sollwert für den Abstand verglichen. Der Sollwert kann dabei erfindungsgemäß insbesondere einer weiteren Amplituden-Korrektur-Kennlinie entnommen werden, die erstellt wurde, indem aus den Spektren der Referenzsignale jeweils der Abstand zwischen der Amplitude der zweithöchsten und der dritthöchsten Spektrallinie im Bereich des betrachteten lokalen Maximums ermittelt wurde.

Je nachdem, wie stark der reale Wert, also der Istwert des Abstandes der Amplituden von zweit- und dritthöchster Spektrallinie von dem Sollwert abweicht, wird der Amplituden-Korrekturwert nach unten hin korrigiert, also reduziert. Je nach Abweichung kann eine Reduzierung der Korrektur auf bis zu 0 erfolgen, was einem völlig unkorrigierten Amplitudenwert entspricht. Es erfolgt somit eine stufenlose Reduzierung der Amplituden-Korrektur zwischen der maximalen Korrektur und keiner Korrektur.

Rechnerisch kann die weitere Korrektur, also die Reduzierung des Amplitudenwertes beispielsweise erfolgen, indem der Amplituden-Korrekturwert mit dem Verhältnis des Istwertes zu dem Sollwert multipliziert wird.

Durch die weitere Korrektur über die erfindungsgemäße Berücksichtigung des Abstandes der Amplituden von zweit- und dritthöchster Spektrallinie können erfindungsgemäß besonders zuverlässige Amplituden-Werte erhalten werden. Dies gilt insbesondere auch für den Fall, dass das Spektrum des zu analysierenden Signals Peaks aufweist, die zunehmend von Hintergrundrauschen oder anderen Signalkomponenten überlagert werden.

Eine weitere Ausführungsform des erfindungsgemäßen Verfahrens zeichnet sich dadurch aus, dass aus den Spektren der Referenzsignale das Verhältnis eines vorgegebenen Sollwertes für die Amplitude der höchsten Spektrallinie zu dem jeweiligen Istwert der Amplitude der höchsten Spektrallinie ermittelt wird, und die ermittelten Verhältnisse insbesondere in einem Graphen gegen die variierte Frequenz oder gegen das Verhältnis n/N oder gegen den Offset der Frequenz n/N*Δf aufgetragen wird.

Aus den Verhältnissen des vorgegebenen Sollwertes der Amplitude der höchsten Spektrallinie und dem jeweiligen Istwert der Amplitude der höchsten Spektrallinie kann dann beispielsweise der minimale und/oder der maximale Wert des Verhältnisses ermittelt werden, und der maximale Wert kann insbesondere als Plausibilitätskriterium herangezogen werden.

Der minimale Wert des Verhältnisses von Sollwert und Istwert ist in der Regel in dem Graphen an der Stelle $n = 0$ zu finden. Das Maximum liegt in der Regel an der Position $n = N/2$ also bei derjenigen Frequenz, die in der Mitte zwischen den beiden Linien, zwischen denen variiert wurde, liegt.

Der vorgegebene Sollwert für die Amplitude der höchsten Spektrallinie kann beispielsweise der bekannte Wert der Amplitude der Referenzsignale sein, die im einfachsten Falle 1 ist.

Die unter Anwendung des erfindungsgemäßen Verfahrens aufbereiteten Amplitudenwerte können - genau wie die aufbereiteten Frequenzwerte - beispielsweise zur Information über den Zustand der Anlage, insbesondere Gasturbine, zur Ableitung von Meldungen oder zur Rückwirkung auf den Betrieb der Anlage herangezogen werden.

Die vorstehende Aufgabe wird ferner gelöst durch eine Vorrichtung für die Durchführung des Verfahrens zur Analyse eines Signals gemäß der vorliegenden Erfindung, umfassend eine Datenerfassungs- und -auswerteeinrichtung, welche ausgebildet ist, um

- mit wenigstens einem Sensor zur Aufnahme eines zu analysierenden Signals, insbesondere wenigstens einem Drucksensor und/oder wenigstens einem Schwingungssensor, verbunden zu werden,
- ein mit dem wenigstens einen Sensor aufgenommenes Signal zu erfassen und insbesondere zu filtern und/oder zu digitalisieren,
- das Signal mit einer vorgegebenen Fensterfunktion zu multiplizieren,
- das Signal einer insbesondere schnellen oder diskreten Fourier-Transformation zu unterwerfen, um ein Spektrum des Signals zu erhalten,

wobei die Datenerfassungs- und auswerteeinrichtung ausgebildet und eingerichtet ist, um das Verfahren nach einem der vorhergehenden Ansprüche zur Analyse eines mit dem wenigstens einen Sensor erfassten Signals durchzuführen.

Die Datenerfassungs- und -auswerteeinrichtung kann beispielsweise einen Prozessor oder auch eine digitale Signalprozessorkarte umfassen.

In Weiterbildung umfasst die erfindungsgemäße Vorrichtung wenigstens einen Sensor zur Aufnahme eines zu analysierenden Signals, insbesondere wenigstens einen Drucksensor und/oder wenigstens einen Schwingungssensor, der mit der Datenerfassungs- und -auswerteeinrichtung verbunden ist.

Eine auf diese Weise ausgebildete Vorrichtung ist zur Durchführung des erfindungsgemäßen Verfahrens besonders geeignet.

Die erfindungsgemäße Vorrichtung kann beispielsweise für eine "Brummanalyse" an einer Gasturbine oder auch für eine Schwingungsanalyse an rotierenden Maschinen zum Einsatz kommen.

Im Rahmen der "Brummanalyse" können die Verbrennungsgeräusche einer Gasturbine analysiert werden.

Hierzu kann im Brennraum und/oder an den Brennern der Gasturbine ein Sensor bzw. können mehrere Sensoren vorgesehen werden, um ein zu den Verbrennungsgeräuschen korrespondierendes Signal zeitabhängig zu erfassen. Als Sensoren können beispielsweise Drucksensoren, insbesondere Wechseldruckaufnehmer Verwendung finden.

Da sich die Druckschwingungen auch auf umliegende Gehäuseteile übertragen, können alternativ oder zusätzlich für die Drucksignalerfassung auch Beschleunigungssensoren zum Einsatz kommen.

Je nach Aufbau der Maschine kann es auch zweckdienlich sein, eine Kombination aus Druck- und Beschleunigungssensoren vorzusehen.

Für die Erfassung der Bewegung von Maschinenteilen für eine Schwingungsanalyse können als Schwingungssensoren beispielsweise Weg-, Geschwindigkeits- oder Beschleunigungssensoren verwendet werden.

Die zum Einsatz kommenden Sensoren für die Aufnahme eines oder mehrerer zu analysierender Signale können Teil der erfindungsgemäßen Vorrichtung sein. Alternativ kann die erfindungsgemäße Vorrichtung mit bereits vorhandenen Sensoren, beispielsweise eines bereits installierten Zustandsüberwachungssystems, verbunden werden.

Die resultierenden, mit dem oder den Sensoren aufgenommenen Druck- und/oder Beschleunigungssignale können mit Hilfe einer entsprechend ausgestalteten Datenerfassungs- und auswerteeinrichtung der erfindungsgemäßen Vorrichtung insbesondere hochaufgelöst elektrisch erfasst werden, welche entsprechend ausgebildet und eingerichtet ist. Es kann auch eine Filterung sowie eine Digitalisierung der erfassten Signale mit der Datenerfassungs- und auswerteeinrichtung durchgeführt werden.

Die Datenerfassungs- und auswerteeinrichtung ist ferner ausgestaltet und eingerichtet, um das Signal mit einer vorgegebenen Fensterfunktion zu multiplizieren und einer insbesondere schnellen oder diskreten Fourier-Transformation zu unterziehen. Dabei kann das Signal insbesondere stückweise einer Fourier-Transformation unterzogen werden.

Das erhaltene Spektrum des Signals wird dann herangezogen, um das erfindungsgemäße Verfahren durchzuführen, es wird also bereitgestellt, und es wird in dem Spektrum im Bereich zumindest eines lokalen Maximums die höchste Spektrallinie und die zu dieser unmittelbar benachbarte zweithöchste Spektrallinie ermittelt, sowie die weiteren Schritte des erfindungsgemäßen Verfahrens durchgeführt. Dabei ist die Datenerfassungs- und auswerteeinrichtung der erfindungsgemäßen Vorrichtung zur Durchführung der Schritte des erfindungsgemäßen Verfahrens ausgebildet und eingerichtet.

Sind mehrere Frequenzbereiche in dem Spektrum des zu analysierenden Signals von Interesse, so können diese getrennt betrachtet werden.

Für die Durchführung des erfindungsgemäßen Verfahrens kann in der Datenerfassungs- und auswerteeinrichtung wenigstens eine Frequenz-Korrektur-Kennlinie für wenigstens eine Fensterfunktion abgelegt sein und insbesondere wenigstens eine Amplituden-Korrektur-Kennlinie für die wenigstens eine Fensterfunktion abgelegt sein und/oder die Datenerfassungs- und auswerteeinrichtung ist ausgebildet und eingerichtet, um wenigstens eine Frequenz-Korrektur-Kennlinie und insbesondere wenigstens eine Amplituden-Korrektur-Kennlinie unter Heranziehung mehrerer Referenzsignale für die Fensterfunktion zu erstellen.

Nachfolgend wird die vorliegende Erfindung anhand eines Ausführungsbeispiels unter Bezugnahme auf die beiliegende Zeichnung näher erläutert. In der Zeichnung zeigt:

Fig. 1   die im Rahmen des Ausführungsbeispiels verwendete Hamming-Fensterfunktion,

Fig. 2   ein erstes sinusförmiges Referenzsignal der Frequenz $f_0$ = 10,0 Hz,

Fig. 3   das mit der Fensterfunktion aus Figur 1 multiplizierte erste Referenzsignal aus Figur 2,

Fig. 4   ein Auszug des Spektrums des in Figur 3 dargestellten mit der Fensterfunktion aus Figur 1 multiplizierten ersten Referenzsignals,

Fig. 5   ein zweites sinusförmiges Referenzsignal der Frequenz $f_{30}$ = 10,3 Hz

Fig. 6   das mit der Fensterfunktion aus Figur 1 multiplizierte zweite Referenzsignal aus Figur 5,

Fig. 7   ein Auszug des Spektrums des in Figur 6 dargestellten mit der Fensterfunktion aus Figur 1 multiplizierten zweiten Referenzsignals,

Fig. 8   ein drittes sinusförmiges Referenzsignal der Frequenz $f_{50}$ = 10,5 Hz,

Fig. 9   das mit der Fensterfunktion aus Figur 1 multiplizierte dritte Referenzsignal aus Figur 8,

Fig. 10  ein Auszug des Spektrums des in Figur 8 dargestellten mit der Fensterfunktion aus Figur 1 multiplizierten dritten Referenzsignals,

Fig. 11    ein viertes sinusförmiges Referenzsignal der Frequenz $f_{80}$ = 10,8 Hz,

Fig. 12    das mit der Fensterfunktion aus Figur 1 multiplizierte vierte Referenzsignal aus Figur 11,

Fig. 13    ein Auszug des Spektrums des in Figur 12 dargestellten mit der Fensterfunktion aus Figur 1 multiplizierten vierten Referenzsignals,

Fig. 14    ein fünftes sinusförmiges Referenzsignal der Frequenz $f_{100}$ = 11,0 Hz,

Fig. 15    das mit der Fensterfunktion aus Figur 1 multiplizierte fünfte Referenzsignal aus Figur 14,

Fig. 16    ein Auszug des Spektrums des in Figur 15 dargestellten mit der Fensterfunktion aus Figur 1 multiplizierten fünften Referenzsignals,

Fig. 17    ein Diagramm, welches verschiedene AmplitudenVerhältnisse gegen n/N sowie eine AmplitudenKorrektur-Kennlinie für die in Figur 1 dargestellte Fensterfunktion enthält,

Fig. 18    ein Diagramm, welches eines der in Figur 17 dargestellten Verhältnisse über einen weiteren Bereich für n/N zeigt,

Fig. 19    ein Diagramm, welches eine Frequenz-KorrekturKennlinie für die in Figur 1 dargestellte Fensterfunktion enthält,

Fig.20    ein Diagramm, welches eine weitere Amplituden-Korrektur-Kennlinie für die in Figur 1 dargestellte Fensterfunktion enthält,

Fig. 21    ein Spektrum, in welchem zum Vergleich theoretische und reale Werte dargestellt sind, sowie korrigierte Werte für ein theoretisches sowie ein real gemessenes Signal,

Fig. 22    das Spektrum eines ersten zu analysierenden Signals, welches vor der Transformation mit der in Figur 1 dargestellten Fensterfunktion multiplizierte wurde, und

Fig. 23    das Spektrum eines zweiten zu analysierenden Signals, welches vor der Transformation mit der in Figur 1 dargestellten Fensterfunktion multiplizierte wurde.

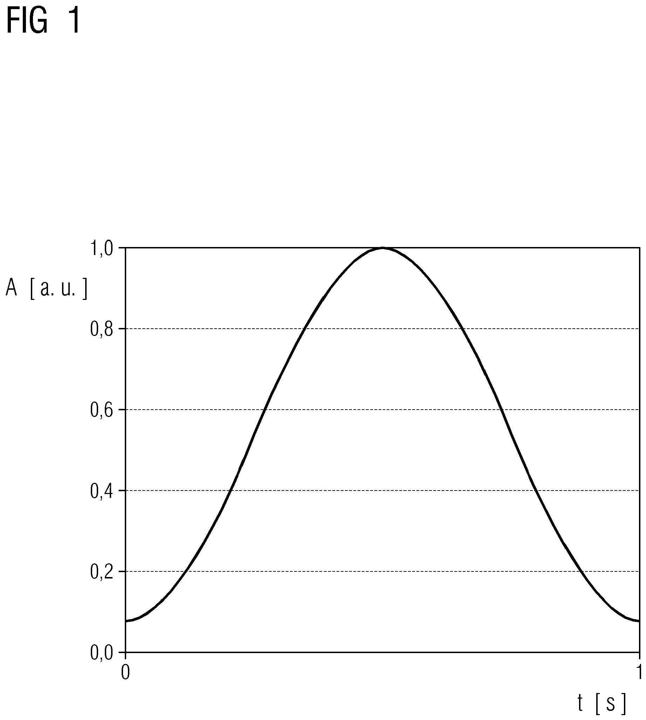

Die Figur 1 zeigt einen Graphen, in dem eine Hamming-Fensterfunktion dargestellt ist, welche bei dem vorliegenden Ausführungsbeispiel des erfindungsgemäßen Verfahrens verwendet wird.

Die Fensterfunktion kommt in an sich bekannter Weise im Rahmen der Fourier-Analyse von Signalen zum Einsatz, indem ein zu analysierendes Signal mit der Fensterfunktion multipliziert wird und im Anschluss eine Fourier-Transformation des mit der Fensterfunktion multiplizierten Signales durchgeführt wird.

Mit der Verwendung der Fensterfunktion geht eine unerwünschte Verbreiterung der den Signalkomponenten des Signals entsprechenden Peaks im Spektrum sowie ein Verringerung der Amplitude einher.

Unter Anwendung des erfindungsgemäßen Verfahrens können die Frequenz und die Amplitude der Signalkomponenten mit höherer Genauigkeit bestimmt werden.

Dazu wird erfindungsgemäß eine Frequenz-Korrektur-Kennlinie herangezogen, welche, wenn eine vorgegebene Fensterfunktion das erste Mal zum Einsatz kommt, zunächst zu erstellen ist. Die Erstellung der spezifischen Frequenz-Korrektur-Kennlinie für die in Figur 1 dargestellte Hamming-Fensterfunktion wird im Folgenden detailliert beschrieben. Im Anschluss wird erläutert, wie die Frequenz und die Amplitude einer oder mehrerer Signalkomponenten eines zu analysierendes Signals erfindungsgemäß korrigiert wird.

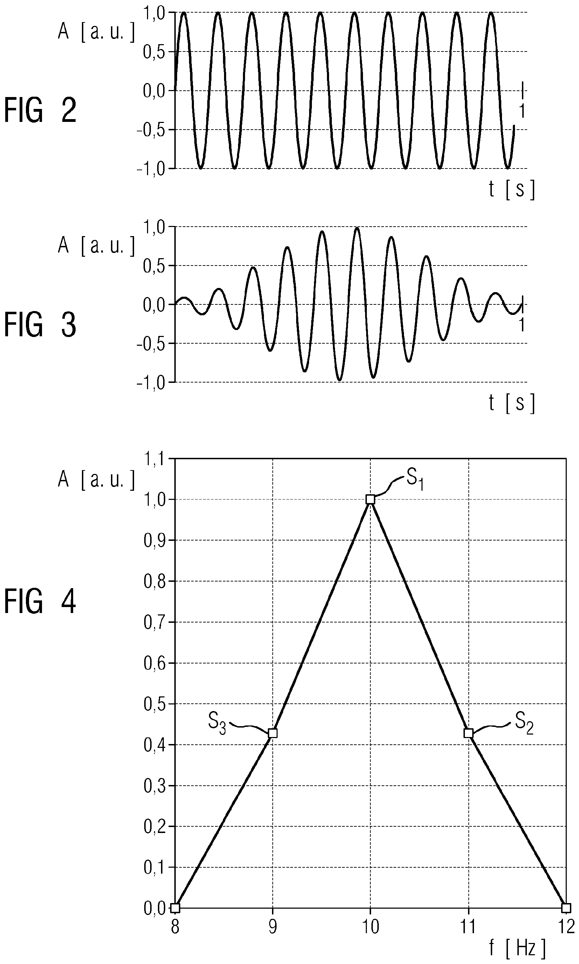

Für die Erstellung der für die Hamming-Fensterfunktion gemäß Figur 1 spezifischen Frequenz-Korrektur-Kennlinie werden in einem ersten Schritt mehrere sinusförmige Referenzsignale bereitgestellt. Dies erfolgt bei dem dargestellten Ausführungsbeispiel, indem ein sinusförmiges Referenzsignal mit einer Frequenz von $f_0$ = 10,0 Hz bereitgestellt wird. Das entsprechende Sinussignal ist in der Figur 2 dargestellt, in welcher die Amplitude A des Signals in beliebigen Einheiten über der Zeit t in Sekunden aufgetragen ist. Der Erfassungszeitraum des Signales ist, wie der Figur 2 entnommen werden kann, eine Sekunde.

Das in Figur 2 dargestellte Referenzsignal mit $f_0$ = 10,0 Hz wird mit der in Figur 1 gezeigten Hamming-Fensterfunktion multipliziert, wodurch das in Figur 3 dargestellte Signal erhalten wird. Anschließend wird das in Figur 3 dargestellte Signal einer schnellen Fourier-Transformation unterworfen, wodurch das zu dem ersten Referenzsignal gehörige Spektrum erhalten wird. Von dem Spektrum ist in Figur 4 ein Auszug für den Frequenzbereich von 8 bis 12 Hz dargestellt. In der Figur 4 ist die Amplitude in beliebigen Einheiten über der Frequenz in Hz aufgetragen. Die Figur 4 zeigt drei Spektrallinien, eine höchste Spektrallinie $S_1$ bei einer Frequenz von 10,0 Hz, eine zu dieser unmittelbar benachbarte zweithöchste Spektrallinie $S_2$ bei einer Frequenz von 11,0 Hz und eine weitere, zu der höchsten Spektrallinie $S_1$ ebenfalls unmittelbar benachbarte dritthöchste Spektrallinie $S_3$ bei 9,0 Hz.

In dem in Figur 4 dargestellten Spektrum sowie in allen im Folgenden dargestellten Spektren sind die Spektrallinien des schematisch durch Quadrate dargestellt. Benachbarte Spektrallinien sind ferner zur besseren Darstellung durch Linien miteinander verbunden, obwohl zwischen den Spektrallinien keine auf den Verbindungslinien liegenden Werte existieren.

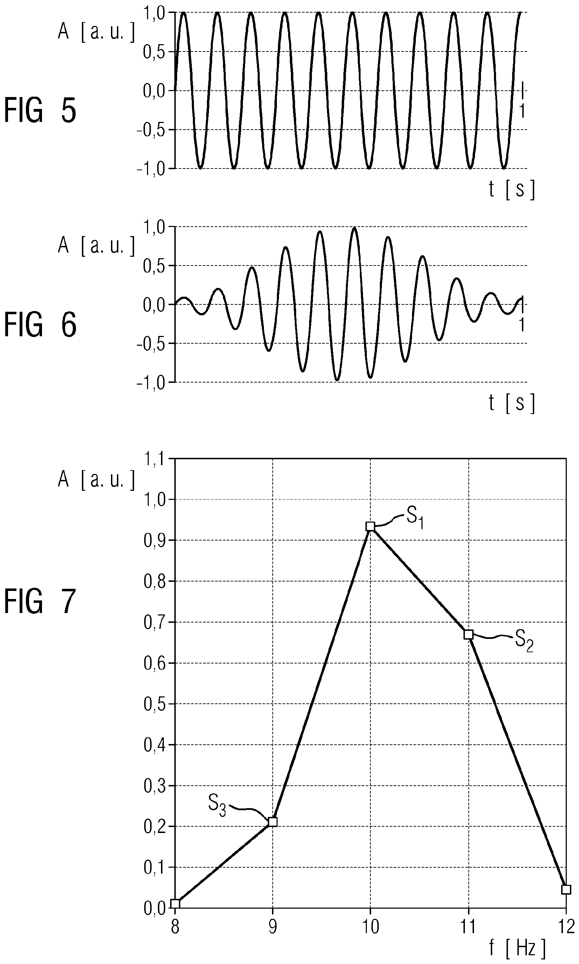

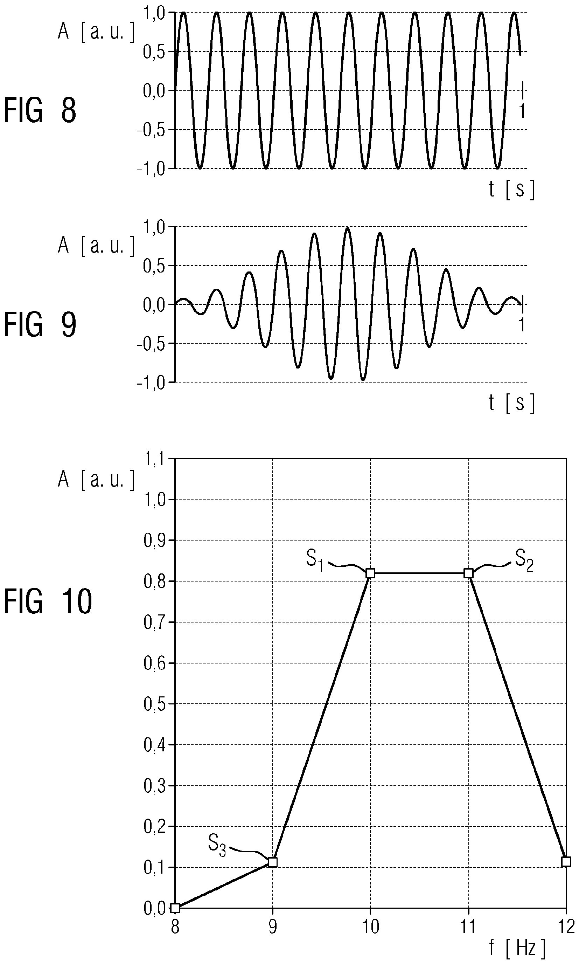

Um den Energieverlust durch die Multiplikation mit der Fensterfunktion auszugleichen, wurden in an sich bekannter Weise die Spektrallinien so umskaliert, dass der Verlust wieder ausgeglichen ist. Für die vorliegende Fensterfunktion aus Figur 1 wurde mit 1/54 % korrigiert. Dies gilt auch für die Spektren in den noch folgenden Figuren 7, 10 13 und 16.

Um für die Erstellung der Frequenz-Korrektur-Kennlinie für die Fensterfunktion aus Figur 1 weitere Referenzsignale anderer Frequenz zu erhalten, wird das in Figur 2 dargestellte sinusförmige Referenzsignal der Frequenz $f_0$ = 10,0 Hz zwischen der Frequenz der Spektrallinie $f_{LinieL}$ bei 10,0 Hz und der Frequenz der zu dieser unmittelbar benachbarten Spektrallinie $f_{LinieL+1}$ bei der Frequenz 11,0 Hz variiert.

Bei dem dargestellten Ausführungsbeispiel findet eine Variierung in N = 100 Schritten statt, so dass 100 weitere Referenzsignale mit den Frequenzen

$$f_n = f_{LinieL} + n/N * \Delta f$$

mit n = 0 ... 100 und der Auflösung $\Delta f$ zu erhalten.

Die Auflösung $\Delta f$ ist bei dem dargestellten Ausführungsbeispiel als $\Delta f$ = 1,0 Hz gewählt.

Von den 100 weiteren Referenzsignalen, welche im Rahmen des beschriebenen Ausführungsbeispiels für die Erstellung der Frequenz-Korrektur-Kennlinie bereitgestellt werden, sind in den Figuren 5, 8, 11 sowie 14 lediglich beispielhaft vier Referenzsignale dargestellt.

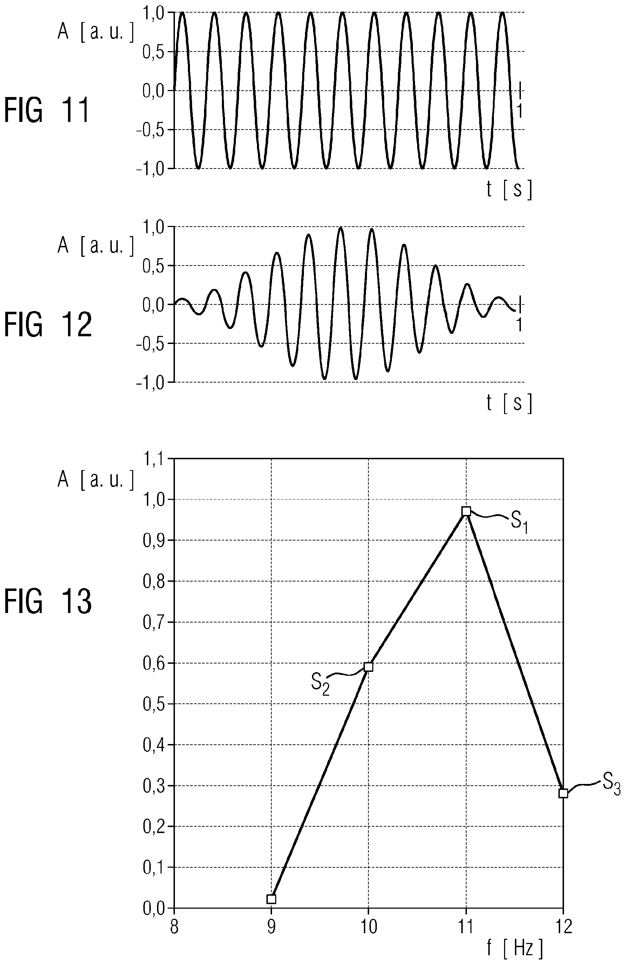

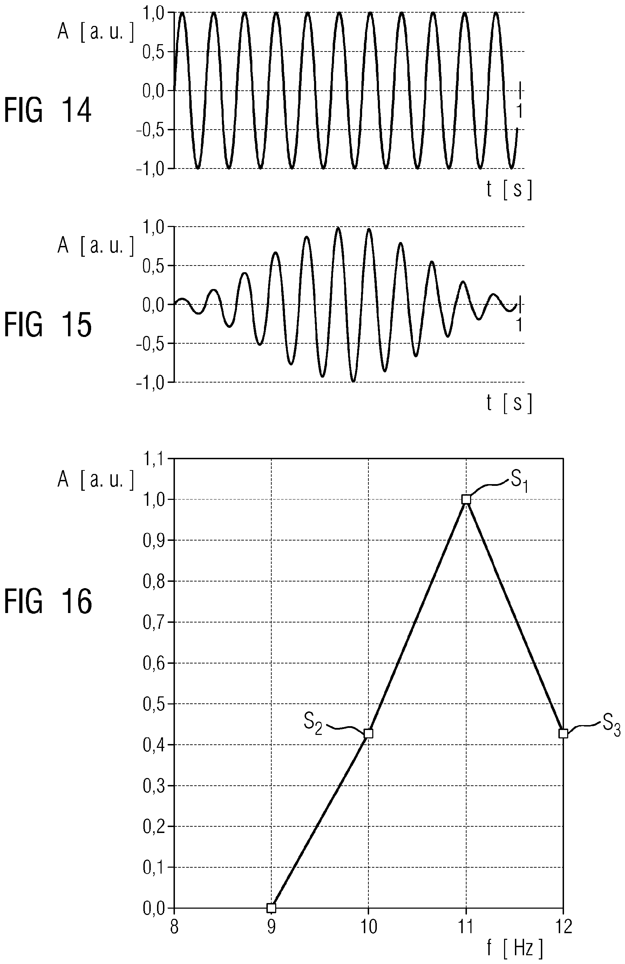

Konkret zeigt die Figur 5 ein Referenzsignal mit einer variierten Frequenz von $f_{30}$ = 10,3 Hz, die Figur 8 ein weiteres Referenzsignal mit einer variierten Frequenz von $f_{50}$ = 10,5 Hz, die Figur 11 ein weiteres Referenzsignal mit einer variierten Frequenz von $f_{80}$ = 10,8 Hz und die Figur 14 ein Referenzsignal mit einer variierten Frequenz von $f_{100}$ = 11,0 Hz.

Das in Figur 2 dargestellte Referenzsignal entspricht somit der Variationsposition n = 0, das in Figur 8 dargestellte Signal entspricht genau der Mitte zwischen den beiden Spektrallinien, nämlich der Position n = 50 und das in Figur 14 dargestellte Referenzsignal entspricht der Position n = 100.

Jedes der 100 weiteren bereitgestellten Referenzsignale wird anschließend mit der in Figur 1 dargestellten Fensterfunktion multipliziert. Für die in den Figuren 5, 8, 11 sowie 14 beispielhaft dargestellten Referenzsignale ist in den Figuren 6, 9, 12 sowie 15 das Ergebnis der Multiplikation mit der in Figur 1 dargestellten Fensterfunktion dargestellt.

Anschließend wird jede der 100 weiteren mit der Figur 1 dargestellten Fensterfunktionen multiplizierten Referenzsignale einer schnellen Fourier-Transformation unterworfen, um für jedes Referenzspektrum ein transformiertes Spektrum zu erhalten.

Für die in den Figuren 5, 8, 11 sowie 14 beispielhaft dargestellten Referenzsignale sind in den Figuren 7, 10, 13 sowie 16 beispielhaft Auszüge der infolge der schnellen Fourier-Transformation erhaltenen Spektren - in Analogie zu Figur 4 für den Frequenzbereich von 8,0 bis 12,0 Hz - dargestellt.

In einem nächsten Schritt wird aus jedem der N+1 transformierten Spektren im Bereich des einzigen lokalen Maximums jeweils die höchste Spektrallinie $S_1$ und die zu dieser benachbarte zweithöchste Spektrallinie $S_2$ ermittelt. Es wird ferner aus jedem transformierten Spektrum der Referenzsignale die Amplitude $A_1$ der höchsten Spektrallinie $S_1$ und die Amplitude $A_2$ der benachbarten zweithöchsten Spektrallinie $S_2$ ermittelt.

Für jedes transformierte Spektrum aller Referenzsignale wird ferner das Verhältnis der Amplitude $A_1$ der höchsten Spektrallinie $S_1$ zu dem Mittelwert $Avg_{12}$ aus dem Amplituden $A_1$, $A_2$ der höchsten und der zweithöchsten Spektrallinie $S_1$, $S_2$ ermittelt. Von den dabei erhaltenen Werten sind in der folgenden Tabelle die Werte für die in den Figuren beispielhaft gezeigten Referenzsignale, also die Frequenzen $f_0$, $f_{30}$, $f_{50}$, $f_{80}$ und $f_{100}$ enthalten:

| n/N [%] | A1 | $A_2$ | $A_3$ | $AVg_{12}$ | $A_1/Avg_{12}$ |
|---------|------|------|------|------|------|
| 0 | 1,00 | 0,43 | 0,43 | 0,71 | 1,40 |

(fortgesetzt)

| n/N [%] | A1 | $A_2$ | $A_3$ | $AVg_{12}$ | $A_1/Avg_{12}$ |
|---|---|---|---|---|---|
| 30 | 0,93 | 0,67 | 0,22 | 0,80 | 1,16 |
| 50 | 0,82 | 0,82 | 0,12 | 0,82 | 1,00 |
| 80 | 0,97 | 0,59 | 0,28 | 0,78 | 1,24 |
| 100 | 1,00 | 0,43 | 0,43 | 0,71 | 1,40 |

Die aus den Spektren aller Referenzsignale ermittelten Verhältnisse $A_1/Avg_{12}$ werden zusammen mit der jeweils zugehörigen Frequenz $f_n$=0...100 desjenigen Referenzsignals, aus dessen Spektrum das jeweilige Verhältnis ermittelt wurde, als Wertepaare abgelegt und auf Basis der Wertepaare wird eine Kennlinie erstellt.

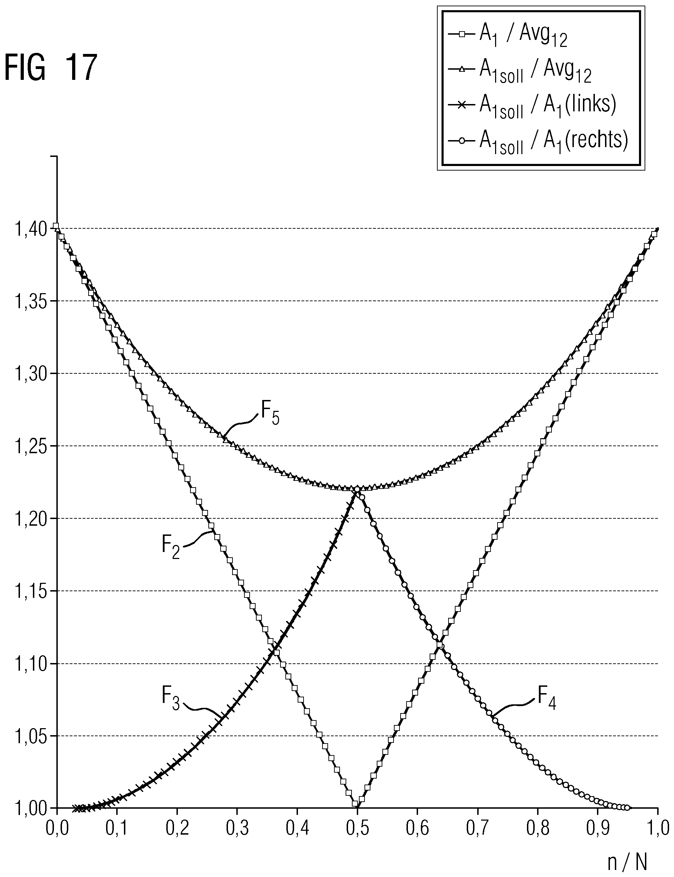

Hierfür werden die erhaltenen Werte für $A_1/Avg_{12}$ zunächst in einem Graphen gegen das Verhältnis n/N aufgetragen, was in Figur 17 dargestellt ist. Die entsprechenden Punkte sind in dem Graphen in Figur 17 durch Quadrate dargestellt.

Es wird dann die Kurve, auf welcher die Werte für $A_1/Avg_{12}$ liegen, in guter Näherung mit linearen Fit-Funktionen angenähert. Wie aus der Figur 17 hervorgeht, können die Werte für die Verhältnisse $A_1/Avg_{12}$ durch zwei Graden angenähert werden, die bei n = 50, also n/N = 0,5 gespiegelt sind. An die in der Figur 17 dargestellten Werte für $A_1/Avg_{12}$ werden demgemäß zwei lineare Fit-Funktionen angelegt. Die erste Fit-Funktion kann als Regressionsgrade durch die Punkte von n/N = 0 bis n/N = 0,5 ermittelt werden. Die weitere lineare Fit-Funktion kann als Regressionsgrade durch die Punkte von n/N = 0,5 bis n/N = 1 ermittelt werden.

Die Spektrallinie $S_1$ bei der Frequenz $f_{LinieL}$ ist die höchste Spektrallinie für n/N von -0,5 bis +0,5, darüber wechselt die höchste Linie zur darauffolgenden Linie. Dies geht auch aus den Figuren 4, 7, 10, 13, und 16 sowie der Figur 18 hervor, welche einen Graphen zeigt, in dem das Verhältnis $A_1/Avg_{12}$ für die Bereiche n/N = 0 bis 0,5 und n/N = 0,5 bis 1 sowie den Bereich n/N = -0,5 bis 0, dargestellt ist. Konkret sind die entsprechenden Werte in dem Graphen für den Bereich n/N = - 0,5 bis n/N = 0 in Form von Dreiecken, für den Bereich n/N = 0 bis n/N = 0,5 in Form von Kreuzen und für den Bereich n/N = 0,5 bis n/N = 1 in Form von Quadraten eingezeichnet.

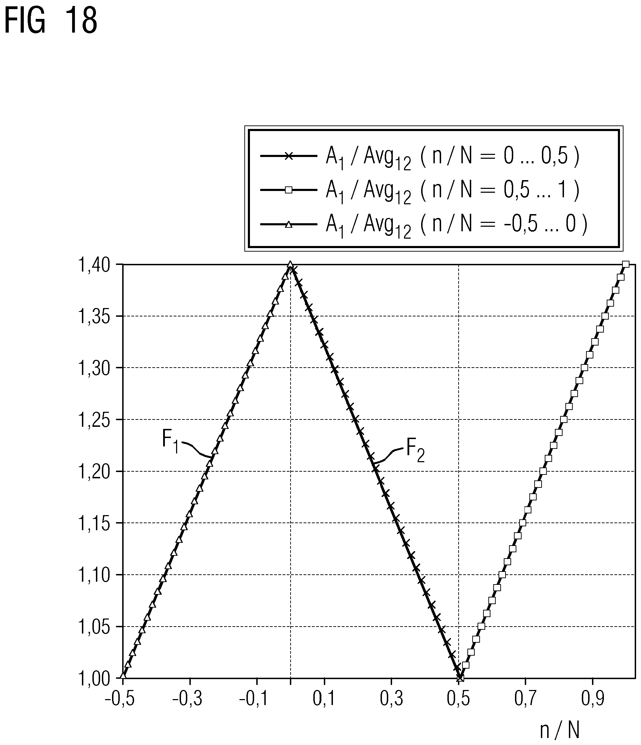

Aus der Figur 18 kann Folgendes über die Symmetrie und die Periodizität entnommen werden.

Für den Bereich von n/N = -0,5 bis n/N = 0,5 gilt:

$$A_1/Avg_{12} \ (n/N) \ = \ A_1/Avg_{12} \ (-n/N)$$

$$A_1/Avg_{12} \ (n/N) \ = \ A_1/Avg_{12} \ (n/N+1)$$

Demgemäß können Werte bzw. Funktionen im Bereich von n/N = - 0,5 bis n/N = 0 auch genutzt werden, sofern der Betrag von n/N, also abs(n/N), im Bereich von n/N = -0,5 bis 0,5 liegt. Funktionen für den Bereich n/N = 0,5 bis n/N = 1 liefern dieselben Ergebnisse, wie Funktionen für n/N = -0,5 bis n/N = 0.

Das trifft auf alle Verhältnisse der Amplituden $A_1$, $A_2$, $A_3$ der höchsten, zweithöchsten und dritthöchsten Spektrallinien $S_1$, $S_2$, $S_3$ zu.

Konkret gilt für alle n/N für den Bereich von -0,5 bis 0:

$$f(A_1, \ A_2, \ A_3, \ n/N) \ = \ f(A_1, \ A_2, \ A_3, \ -n/N)$$

$$f(A_1, \ A_2, \ A_3, \ n/N) \ = \ f(A_1, \ A_2, \ A_3, \ n/N+1)$$

Es gilt für die lineare Fit-Funktionen für den Bereich n/N = -0,5 bis n/N = 0

$$A_1/Avg_{12} \approx (Max(A_1/Avg_{12}) - Min(A_1/Avg_{12}))/0,5*n/N + Max(A_1/Avg_{12})$$

und für den Bereich n/N = 0bis n/N = 0,5

$$A_1/Avg_{12} \approx -(Max(A_1/Avg_{12}) - Min(A_1/Avg_{12}))/0,5*n/N + Max(A_1/Avg_{12})$$

Vorliegend erhält man für die Fensterfunktion aus Figur 1 für den Bereich von n/N = -0,5 bis n/N = 0 eine erste lineare Fit-Funktion

$$F1: y = 0,8139 \ x + 1,4056 \ mit \ x = n/N$$

für den Bereich von n/N = 0 bis n/N = 0,5 eine zweite lineare Fit-Funktion

$$F2: y = -0,7971 \ x + 1,4022 \ mit \ x = n/N$$

In der folgenden Tabelle sind die für eine vorgegebene Fensterfunktion spezifischen Werte $Max(A_1/Avg_{12})$ und $Min(A_1/Avg_{12})$ und die zugehörigen Geradengleichungen für die in Figur 1 dargestellte Hamming-Fensterfunktion, sowie beispielhaft für drei weitere Fensterfunktionen, konkret eine Hanning-Fensterfunktion, eine Tukey 65-Fensterfunktion, also eine Tukey-Fensterfunktion mit $\alpha$ = 0,65, was einem Plateau von 35 % entspricht, und eine Rechteck-Fensterfunktion, aufgeführt:

| Fensterfunktion | Max $(A_1/Avg_{12})$ bei n/N=0,0 | Min $(A_1/Avg_{12})$ bei n/N=0,5 |
|---|---|---|
| Rechteck | 2,00 | 1,00 |
| Hamming | 1,40 | 1,00 |
| Tukey 65 | 1,47 | 1,00 |
| Hanning | 1,33 | 1,00 |

| Geradengleichung $A_1/Avg_{12}$ als Funktion über n/N (-0,5...0) (wenn "MaxIsRight" =WAHR) | Geradengleichung $A_1/Avg_{12}$ als Funktion über n/N (-0,5...0) (wenn"MaxIsRight"=FALSCH) |
|---|---|
| 2,0*n/N + 2,0 | -2,0*n/N + 2,0 |
| 0,8*n/N + 1,40 | -0,8*n/N + 1,40 |
| 0,94*n/N + 1,47 | -0,94*n/N + 1,47 |
| 0,67*n/N + 1,33 | -0,67*n/N + 1,33 |

Kommt alternativ zu dem beschriebenen Ausführungsbeispiel anstelle der Hamming-Fensterfunktion aus Figur 1 eine Hanning-, Tukey 65- oder Rechteck-Fensterfunktion zum Einsatz, so werden einfach die entsprechenden Werte und Funktionen herangezogen.

In einem nächsten Schritt wird ein Sollwert für die Amplitude der höchsten Spektrallinie der Spektren aller Referenzsignale vorgebeben, welcher für das dargestellte Ausführungsbeispiel der bekannten Amplitude der Referenzsignale entspricht, also $A_{1soll}$ = 1. Es wird der Wert des Sollwertes $A_{1Soll}$ geteilt durch den Istwert der Amplitude $A_1$ der höchsten Spektrallinie $S_1$ aus dem Spektrum jedes Referenzsignals gebildet, also $A_{1Soll}/A_1$ bzw. $1/A_1$. Die Werte, die dadurch erhalten werden, sind ebenfalls in dem Graphen in Figur 17 dargestellt, also über n/N aufgetragen. Für den Bereich n/N = 0 bis n/N = 0,5 sind die entsprechenden Punkte durch Kreuze ($A_{1Soll}/A_1$ (links)) und für den Bereich n/N = 0,5 bis n/N = 1 durch Kreise ($A_{1Soll}/A_1$ (rechts))dargestellt.

Wie man der Figur 17 entnehmen kann, liegen die Werte in guter Näherung auf zwei Halbparabeln. An die Werte wird wiederum jeweils eine Fit-Funktion für den Bereich von n = 0 ... 50 sowie für den Bereich n = 50 ... 100 angelegt. Hierfür wird jeweils eine Polynom-Fit-Funktion zweiten Grades als Regressionsparabel durch die Punkte von n/N = 0 bis n/N = 0,5 sowie eine weitere Polynom-Fit-Funktion zweiten Grades als Regressionsparabel durch die Punkte von n/N = 50 bis n/N = 100 ermittelt.

Für das dargestellte Ausführungsbeispiel, also für die in Figur 1 dargestellte Hamming-Fensterfunktion erhält man eine Polynom-Fit-Funktion zweiten Grades F3 für den Wertebereich von n/N = 0 bis n/N = 0,5, nämlich

$$F3: y = 0{,}925\,x^2 - 0{,}0328\,x + 1{,}0008 \text{ mit } x = n/N,$$

sowie für den Bereich von n/N = 0,5 bis n/N = 1 eine weitere Polynom-Fit-Funktion zweiten Grades

$$F4: y = 0{,}9666\,x^2 - 1{,}8925\,x + 1{,}9265 \text{ mit } x = n/N.$$

In einem nächsten Schritt wird überprüft, ob das Minimum der Werte für das Verhältnis $A_{1Soll}/A_1$ an der Position n = 0 liegt und 1 beträgt.

Es wird weiterhin überprüft, ob das Maximum der Werte der Verhältnisse von $A_{1soll}/A_1$ an der Position n = 50 liegt und es wird der Wert des Maximums bestimmt. Bei dem dargestellten Ausführungsbeispiel erhält man folgende Werte für die in Figur 1 dargestellte Hamming-Fensterfunktion:

$$\text{Min}(A_{1Soll}/A_1) = 1{,}0 \quad \text{bei } n/N = 0$$

$$\text{Max}(A_{1Soll}/A_1) = 1{,}22 \quad \text{bei } n/N = 0{,}5$$

Als nächstes wird für jedes der Referenzsignale der Sollwert $A_{1soll} = 1$ dividiert durch den Mittelwert zwischen den Amplituden der höchsten und der benachbarten zweithöchsten Spektrallinie $Avg_{12}$ berechnet, also $A_{1soll}/Avg_{12}$. Die erhaltenen Werte werden ebenfalls in einem Graphen über n/N aufgetragen. Die Werte, welche man für die in Figur 1 dargestellte Hamming-Fensterfunktion erhält, sind ebenfalls in dem Graphen in Figur 17 dargestellt. Die entsprechenden Punkte sind in der Figur 17 durch Dreiecke dargestellt.

Die Kurve, auf der die Punkte $A_{1soll}/Avg_{12}$ liegen, kann in guter Näherung als Parabel angenommen werden und ist ebenfalls spezifisch für die in Figur 1 dargestellte Hamming-Fensterfunktion. Bei dem dargestellten Ausführungsbeispiel erhält man für eine Polynom-Fit-Funktion zweiten Grades

$$F5: y = 0{,}7081\,x^2 - 0{,}7083\,x + 1{,}3979 \text{ mit } x = n/N.$$

Anschließend werden der Maximalwert und der Minimalwert für $A_1/Avg_{12}$ ermittelt, also Min $(A_{1soll}/Avg_{12})$ und Max $(A_{1soll}/Avg_{12})$. Das Minium sollte an der Position n = 50 bei $A_1/Avg_{12} = 1$ liegen. Das Maximum, welches spezifisch für die Fensterfunktion ist, sollte an der Position n = 0 auftreten.

In der folgenden Tabelle sind die entsprechenden Werte wieder für die Hamming-Fensterfunktion aus Figur 1 und die drei weiteren beispielhaft genannten Fensterfunktion aufgeführt:

| Fensterfunktion | Min ($A_{1soll}/A_1$) bei n/N=0,0 | Max ($A_{1soll}/A_1$) bei n/N=0,5 |
|---|---|---|
| Rechteck | 1,00 | 1,55 |
| Hamming | 1,00 | 1,22 |
| Tukey 65 | 1,00 | 1,25 |
| Hanning | 1,00 | 1, 18 |

Die Parabelgleichungen aller für diese vier Fensterfunktionen sind in der folgenden Tabelle enthalten:

| Fensterfunktion | Parabel = f(n/N) mit x = abs(n/N) |
|---|---|
| Rechteck | $A_{1soll}/Avg_{12} = 1{,}6673x^2 - 1{,}669x + 1{,}9701$ |
| Hamming | $A_{1soll}/Avg_{12} = 0{,}7081x^2 - 0{,}7083x + 1{,}3979$ |
| Tukey 65 | $A_{1soll}/Avg_{12} = 0{,}8702x^2 - 0{,}8705x + 1{,}4614$ |
| Hanning | $A_{1soll}/Avg_{12} = 0{,}6152x^2 - 0{,}6152x + 1{,}3309$ |

Soll nun wenigstens eine Signalkomponente eines zu analysierenden zeitabhängig erfassten Signales hinsichtlich der Frequenz und der Amplitude erfindungsgemäß korrigiert werden, wird wie folgt vorgegangen.

Ein Spektrum des zu analysierenden Signals, welches erhalten wurde, indem das Signal mit er vorgegebenen Hamming-Fensterfunktion aus Figur 1 multipliziert und anschließend einer schnellen Fourier-Transformation unterworfen wurde, wird zunächst bereitgestellt.

Im Folgenden wird zur Veranschaulichung von einem zu analysierenden Signal ausgegangen, welches - genau wie die in den Figuren 4, 7 10, 13 und 16 dargestellten Referenzsignale - eine reine Sinusform aufweist, welches jedoch eine Frequenz 10,27 Hz und eine Amplitude von 2,97 aufweist.

Obwohl das erfindungsgemäße Verfahren zur Korrektur von Signalen unbekannter Frequenz und Amplitude eingesetzt werden kann, wird zu Veranschaulichungszwecken zunächst von dem vorgenannten bekannten Signal ausgegangen.

Da das zu analysierende Signal sehr ähnlich aussieht, wie das in Figur 5 dargestellte Signal, ist dieses nicht nochmals dargestellt.

Die Auflösung des Spektrums des zu analysierenden Signals ist - genau wie bei den Referenzsignalen - $\Delta f = 1,0$ Hz.

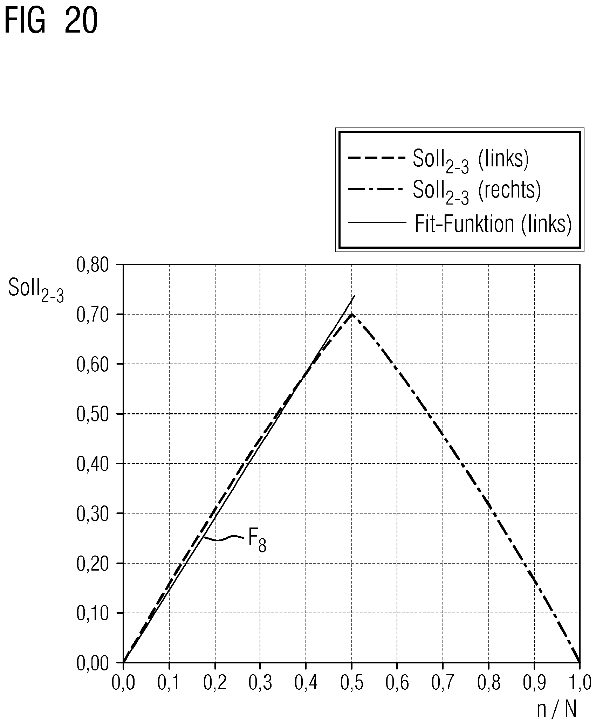

In dem bereitgestellten Spektrum des zu analysierenden Signals, welches der Figur 20 entnommen werden kann, wird im Bereich des lokalen Maximums die höchste Spektrallinie $S_1$ und die zu dieser benachbarte zweithöchste Spektrallinie $S_2$ ermittelt und die Amplitude $A_1$ der höchsten Spektrallinie $S_1$ und die Amplitude $A_2$ der zu dieser benachbarten zweithöchsten Spektrallinie $S_2$ wird bestimmt. In der Figur 20 sind die Spektrallinien des Spektrums wie in den Figuren 4, 7, 10, 13 und 16 schematisch durch Quadrate dargestellt, die zur Veranschaulichung mit Linien verbunden sind.

Damit ist die auch die Frequenz der höchsten Spektrallinie $S_1$, die Frequenz der zweithöchsten Spektrallinie $S_2$ sowie die Frequenz der dritthöchsten Spektrallinie $S_3$ bekannt. Vorliegend erhält man als Frequenz der höchsten Spektrallinie $S_1$ 10 Hz, als Frequenz der zweithöchsten Spektrallinie $S_2$ 11 Hz und als Frequenz der dritthöchsten Spektrallinie $S_3$ 9 Hz.

Darüber hinaus wird die zu der höchsten Spektrallinie $S_1$ benachbarte dritthöchste Spektrallinie $S_3$ ermittelt und auch die Amplitude $A_3$ der dritthöchsten Spektrallinie $S_3$ wird bestimmt.

Im nächsten Schritt wird das Verhältnis der Amplitude $A_1$ der höchsten Spektrallinie $S_1$ zu dem Mittelwert $Avg_{12}$ aus den Amplituden $A_1$, $A_2$ der höchsten und der zweithöchsten Spektrallinie $S_1$, $S_2$ ermittelt.

Für das vorliegende Beispiel erhält man:

| $A_1$ | $A_2$ | $A_3$ | $Avg_{12}$ | $A_1/Avg_{12}$ |
|---|---|---|---|---|
| 2,82 | 1,90 | 0,73 | 2,36 | 1,19 |

Weist das zu analysierende Signal - abweichend von dem vorliegenden Beispiel des reinen Sinussignals - mehrere Peaks in seinem Spektrum auf, können die vorgenannten Werte für mehrere, wenn erwünscht bzw. erforderlich, alle Peaks ermittelt werden, um mehrere bzw. alle Signalkomponenten hinsichtlich ihrer Frequenz zu korrigieren.

An die Ermittlung von den Spektrallinien $S_1$, $S_2$ und $S_3$ sowie der zugehörigen Amplituden $A_1$, $A_2$ und $A_3$ können sich einige Plausibilitäts-Überprüfungsschritte anschließen. Zum einen kann nochmals überprüft werden, ob die höchste Spektrallinie $S_1$ tatsächlich zwischen der zweithöchsten Spektrallinie $S_2$ und der dritthöchsten Spektrallinie $S_3$ liegt und ob die zugehörigen Spektrallinien aufeinanderfolgend sind, also keine weiteren Spektrallinien dazwischen liegen.

Es können dann insbesondere auch Sonderfälle ermittelt werden, z.B., dass die höchste Spektrallinie $S_1$ bei der Frequenz von 0 Hz liegt und dann keine benachbarte Spektrallinie $S_3$ existiert.

Ist dem nicht so, findet keine erfindungsgemäße Korrektur von Frequenz oder Amplitude statt.

Um aus den Messwerten zu ermitteln, ob der Frequenzoffset n/N größer als 0,5 oder kleiner als 0,5 ist, wird der Parameter "MaxIsRight" eingeführt, welcher wahr oder falsch sein kann.

Es gilt "MaxIsRight" = wahr, wenn die höchste Spektrallinie $S_1$ rechts von der benachbarten zweithöchsten Spektrallinie $S_2$, also bei betragsmäßig größeren Frequenzen, liegt, was für n/N größer als 0,5 gilt. Ist dem nicht so, gilt "MaxIsRight" = falsch, ist also n/N kleiner als 0,5. Da die Frequenz-Korrektur-Kennlinie, wie der Figur 17 entnommen werden kann, symmetrisch zu n = N/2 ist, wird dies im Folgenden zur Fallunterscheidung genutzt.

Bei dem zu analysierenden Beispielsignal gilt "MaxIsRight" = falsch, da die höchste Spektrallinie $S_2$ nicht rechts von der zweithöchsten Spektrallinie $S_2$, sondern links von dieser liegt. Die Frequenz von $S_1$ ist nämlich 10 Hz, die Frequenz von $S_2$ ist 11 Hz und die Frequenz von $S_3$ ist 9 Hz.

Dass die höchste Spektrallinie $S_1$ für n/N größer 0,5 rechts von S2 und für n/N kleiner 0,5 links von S2 liegt, geht auch aus den Figuren 4, 7, 10, 13 und 16 hervor.

Wegen der Abhängigkeit des Amplituden-Verhältnisses $A_1/Avg_{12}$ von dem Frequenz-Offset n/N, welcher für die Hamming-Fensterfunktion aus Figur 1 annähernd linear ist (vgl. Fig. 17) kann erfindungsgemäß von dem aus dem Spektrum des zu analysierenden Messsignals ermittelten Verhältnis $A_1/Avg_{12}$ auf den durch die Fensterfunktion bedingten Frequenz-Offset n/N rückgeschlossen werden.

Hierfür werden die linearen Fit-Funktionen F1 und F2 aus der Figur 17 umgestellt von $A_1/Avg_{12}$ über n/N zu n/N über $A_1/Avg_{12}$.

Die vorstehenden linearen Fit-Funktionen F1 und F2 werden demgemäß umgestellt zu

$$\texttt{n/N = -0,5*(A}_1\texttt{/Avg}_{12}\texttt{-Max(A}_1\texttt{/Avg}_{12}\texttt{)/((Max(A}_1\texttt{/Avg}_{12}\texttt{)-Min(A}_1\texttt{/Avg}_{12}\texttt{))}$$

für den Bereich n/N = 0 bis n/N = 0,5, also wenn "MaxIsRight" = FALSCH und

$$\texttt{n/N = 0,5*(A}_1\texttt{/Avg}_{12}\texttt{-Max(A}_1\texttt{/Avg}_{12}\texttt{)/((Max(A}_1\texttt{/Avg}_{12}\texttt{)-Min(A}_1\texttt{/Avg}_{12}\texttt{))}$$

für den Bereich n/N = 0,5 bis n/N = 1 und aufgrund der Periodizität der Funktion für den Bereich n/N = -0,5 bis n/N = 0, also für "MaxIsRight" = WAHR.

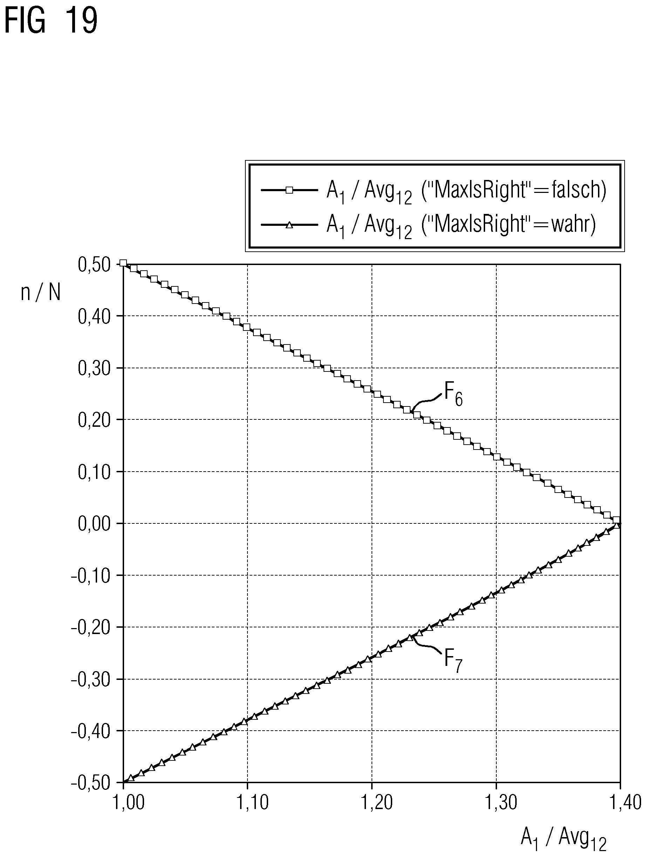

Das Ergebnis, also die umgestellten Funktionen, sind in der Figur 19 dargestellt. In Figur 19 sind die Werte für den Bereich n/N = 0 bis n/N = 0,5 in Form von Quadraten und für den Bereich n/N = -0,5 bis n/N = 0 in Form von Dreiecken eingetragen.

Vorliegend erhält man konkret für den Bereich n/n = 0 bis n/N = 0,5 die obere Fit-Funktion F6 in Figur 19, nämlich

$$\texttt{F6: y = -1,2496 x +1,7527 mit x = A}_1\texttt{/Avg}_{12}$$

und für den Bereich n/N =-0,5 bis n/N = 0

$$\texttt{F7: y = 1,2496 x - 1,7527 mit x = A}_1\texttt{/Avg}_{12}\texttt{.}$$

In der folgenden Tabelle sind wiederum die entsprechenden umgestellten Geradengleichungen für die Fensterfunktionen enthalten:

| Fensterfunktion | Geradengleichung n/N(-0 , 5...0) als Funktion über $A_1/Avg_{12}$ (wenn"MaxIsRight" = WAHR) | Geradengleichung n/N (0...0,5) als Funktion über $A_1/Avg_{12}$ (wenn"MaxIsRight" = FALSCH) |
|---|---|---|
| Rechteck | 0,5* ($A_1Avg_{12}$-2, 00) / (1,0) bzw. 0, 5*$A_1$/$Avg_{12}$-1, 00 | -0,5* ($A_1Avg_{12}$-2, 00) / (1, 0) bzw. -0, 5*$A_d$$Avg_{12}$+1, 00 |
| Hamming | 0,5* ($A_1$/$Avg_{12}$-1,40) / (0,4) bzw. 1, 25*$A_1$/$Avg_{12}$-1,75 | -0,5* ($A_1$/$Avg_{12}$-1,40) / (0,4) bzw. -1, 25*$A_1$/$Avg_{12}$+1,75 |
| Tukey 65 | 0,5*($A_1$/$Avg_{12}$-1,47) / (0,47) bzw. 1, 07*$A_1$/$Avg_{12}$-1,57 | -0,5* ($A_1$/$Avg_{12}$-1,47) / (0,47) bzw. -1,07*$A_1$/$Avg_{12}$+1,57 |
| Hanning | 0,5*($A_1$/$Avg_{12}$-1,33)/(0,33) bzw. 1, 5*$A_1$/$Avg_{12}$-2,00 | -0,5* ($A_1$/$Avg_{12}$-1,33) / (0,33) bzw. -1,5*$A_1$/$Avg_{12}$+2,00 |

Aus dem aus dem Spektrum des zu analysierenden Signals ermittelten Verhältnis $A_1/Avg_{12}$ kann nun unter Heranziehung der Frequenz-Korrektur-Kennlinie aus Figur 19 ein Wert für n/N ermittelt werden. Vorliegend erhält man n/N = 0,26, was auch der folgenden Tabelle entnommen werden kann:

| $A_1$ | $A_2$ | $A_3$ | $Avg_{12}$ | $A_1/Avg_{12}$ | MaxIsRight | n/N |
|---|---|---|---|---|---|---|
| 2,82 | 1,90 | 0,73 | 2,36 | 1,19 | FALSCH | 0,26 |

Abschließend wird die Frequenz der höchsten Spektrallinie $S_1$, welche aus dem Spektrum des zu analysierenden Signal zu $f_{LinieL}$ = 10 Hz entnommen wurde, erfindungsgemäß korrigiert.

Konkret wird die korrigierte Frequenz abgeschätzt zu

$$f_{nkorr} = f_{LinieL} + n/N * \Delta f$$

Für $f_{LinieL}$ = 10 Hz, n/N = 0,26 und $\Delta f$ = 1 Hz erhält man eine korrigierte Frequenz der höchsten Spektrallinie $S_1$

$f_{nkorr}$ = 10,26 Hz,

was mit der tatsächlichen Frequenz der Signalkomponente gut übereinstimmt.

Nachdem die Frequenz auf die erfindungsgemäße Weise korrigiert wurde, kann eine erfindungsgemäße Korrektur der Amplitude der Spektrallinie durchgeführt werden.

Dazu wird aus dem Frequenz-Korrekturwert für die höchste Spektrallinie unter Heranziehung einer Amplituden-Korrektur-Kennlinie, welche für die vorgegebene Fensterfunktion gemäß Figur 1 unter Verwendung von den N = 101 Referenzsignalen unterschiedlicher Frequenz erstellt wurde, eine korrigierte Amplitude ermittelt.

Konkret wird unter Heranziehung des Frequenz-Offsets n/N = 0,26 aus der Regressionsparabeln zu $A_{1soll}/Avg_{12}$, also der Polynom-Fit-Funktion F5 aus Figur 17, die als Amplituden-Korrektur-Kennlinie herangezogen wird, eine korrigierte Amplitude $A_{1KorrMax}$ berechnet.

Konkret wird der aus dem Spektrum des zu analysierenden Signal ermittelte Mittelwert der Amplitude $A_1$ der höchsten Spektrallinie $S_1$ und der Amplitude $A_2$ der zweithöchsten Spektrallinie $S_2$ mit der Fit-Funktion F5 multipliziert:

$$A_{1KorrMax} = Avg_{12gemessen} * F5$$

mit

$$F5: y = 0,7081 \; x^2 - 0,7073 \; x + 1,3979 \; \text{mit} \; x = n/N.$$

berechnet. Für n/N = 0,26 und $Avg_{12gemessen}$ = 2,36 erhält man für die korrigierte Amplitude
$A_{1KorrMax}$ = 2,98,
was der tatsächlichen Amplitude von 2,97 gut entspricht.

Das erfindungsgemäße Verfahren liefert für die korrigierten Amplituden Werte mit den Eigenschaften

$$A_{1korrMax} > A_1.$$

Mit $A_{1korrMax}$ = A1*Max $(A_{1soll}/A_1)$ liegt die Differenz $\Delta_{A1korrMax}$ = $A_{1korrMax}$ - $A_1$ zwischen 0 und $A_1$* (Max $(A_{1soll}/A_1)$ -1) und die prozentuale Änderung $\Delta_{A1korrMax}/A_1$ liegt zwischen 0 % und Max $(A_{1soll}/A_1)$ -1 (etwa 22% Erhöhung beim Hamming-Fenster) . Die erfindungsgemäße Amplitudenkorrektur kann, genau wie die erfindungsgemäße Korrektur der Frequenz, für nur eine Signalkomponente eines zu analysierenden Signals oder auch für mehrere, insbesondere alle Signalkomponenten eines zu analysierenden Signals durchgeführt werden, wobei dann - völlig analog zu der Vorgehensweise bei der Frequenz-Korrektur - für jedes der betrachteten lokalen Maxima jeweils die Amplitude der höchsten Spektrallinie korrigiert wird, nachdem deren Frequenz korrigiert wurde.

Insbesondere für Signalgemische, deren Komponenten hinreichenden Abstand zueinander haben, können unter Anwendung des erfindungsgemäßen Verfahrens die Frequenz und die Amplitude von Signalkomponenten im Ergebnis besonders zuverlässig bestimmt werden.

Treffen diese Bedingungen zunehmend weniger zu, überlagern sich also beispielsweise Komponenten oder sind Hintergrundrauschen und Messfehler vorhanden, umfasst das zu analysierende Signal auch Komponenten einer von einem Sinus abweichenden Form und/oder Hintergrundrauschen, kann es vorteilig sein, die erfindungsgemäße Amplitudenkorrektur anzupassen.

Hierfür werden erfindungsgemäß die Amplituden $A_3$ der dritthöchsten Spektrallinien $S_3$ aus den Spektren der 101 Referenzsignale ermittelt wurden, herangezogen.

Um zu ermitteln, wie weit ein betrachteter Peak aus dem Untergrund herausragt, ob er also noch als alleinstehender Peak betrachtet werden kann, wird für die vorgegebene Fensterfunktion der Abstand $Soll_{2-3}$ der Amplitude $A_2$ der zweithöchsten Spektrallinie zu der Amplitude $A_3$ der dritthöchsten Spektrallinie aus den Spektren aller Referenzsignale ermittelt.

Die real gemessenen Werte, also die aus dem Spektrum eines zu analysierenden Signals ermittelten Werte für den Abstand werden dann mit den theoretischen Werten aus der Kennlinie verglichen.

Die aus den Spektren der Referenzsignale ermittelten Abstände $Soll_{2-3}$ werden in einem Graphen gegen das Verhältnis n/N aufgetragen, und an die in dem Graphen dargestellten Werte werden zwei lineare Fit-Funktion angelegt.

In Figur 20 sind die Werte für den Abstand $Soll_{2-3}$ über n/N aufgetragen. Für den Bereich von n/N = 0 bis n/N = 0,5 in Form einer gestrichelten Linie und für den Bereich n/N = 0,5 bis n/N = 1 in Form einer Strich-Punkt-Linie.

An die Werte werden in dem Bereich von n/N = 0 bis n/N = 0,5 eine erste lineare Fit-Funktion F8 und in dem Bereich n/N = 0,5 bis n/N = 1 eine zweite lineare Fit-Funktion angelegt. In der Figur 19 ist nur die erste Fit-Funktion F8 dargestellt. Die beiden linearen Fit-Funktionen sind symmetrisch um n/N = 0,5 und n/N = 0.

Für die Hamming-Fensterfunktion und die drei weiteren Fensterfunktionen gilt:

| Fensterfunktion | Gerade = f(n/N) mit x = n/N [0...+-0,5] |
|---|---|
| Rechteck | $Soll_{2-3}=A_{1korrMax}*abs\,(0,67x)$ |
| Hamming | $Soll_{2-3}=A_{1korrMax}*abs\,(1,47x)$ |
| Tukey 65 | $Soll_{2-3}=A_{1korrMax}*abs\,(1,60x)$ |
| Hanning | $Soll_{2-3}=Ai_{korrMax}*abs\,(1,41x)$ |

Die Kurve wird für $A_{1Soll}$ = 1 normiert ermittelt und kann dann mit dem realen $A_{1Soll}$ skaliert werden, also mit $A_{1korrMax}$. Da die Verhältnisse der Amplituden $A_1$, $A_2$, $A_3$ der höchsten, zweithöchsten und dritthöchsten Spektrallinie $S_1$, $S_2$, $S_3$ für alle $A_1 > 0$ konstant sind, ist auch die Differenz $A_2 - A_3$ proportional zu $A_1$.

Der Korrekturwert $\Delta A_{1korrRed} = A_{1korrMax} - A_1$ wird in dem Maße reduziert, in dem der theoretische Abstandswert $Soll_{2-3}$ von dem tatsächlichen Abstandswert $Ist_{2-3}$ abweicht, wobei $Ist_{2-3}$ der aus dem Spektrum des zu analysierenden Signals ermittelte Abstand der Amplitude $A_2$ der zweithöchsten Spektrallinie $S_2$ zu der Amplitude $A_3$ der dritthöchsten Spektrallinie $S_3$ ist.

Es wird von einem reduzierten Korrekturwert $\Delta A_{1korrRed}$ für die Amplitude ausgegangen, mit

$$\Delta A_{1korrRed}/\Delta A_{1korrMax} = Ist_{2-3}/Soll_{2-3}$$

und

$$(A_{1korrRed} - A_1)/(A_{1korrMax} - A_1) = Ist_{2-3}/Soll_{2-3}$$

$$A_{1korrRed} = A_1 + (A_{1korrMax} - A_1)*(Ist_{2-3}/Soll_{2-3})$$

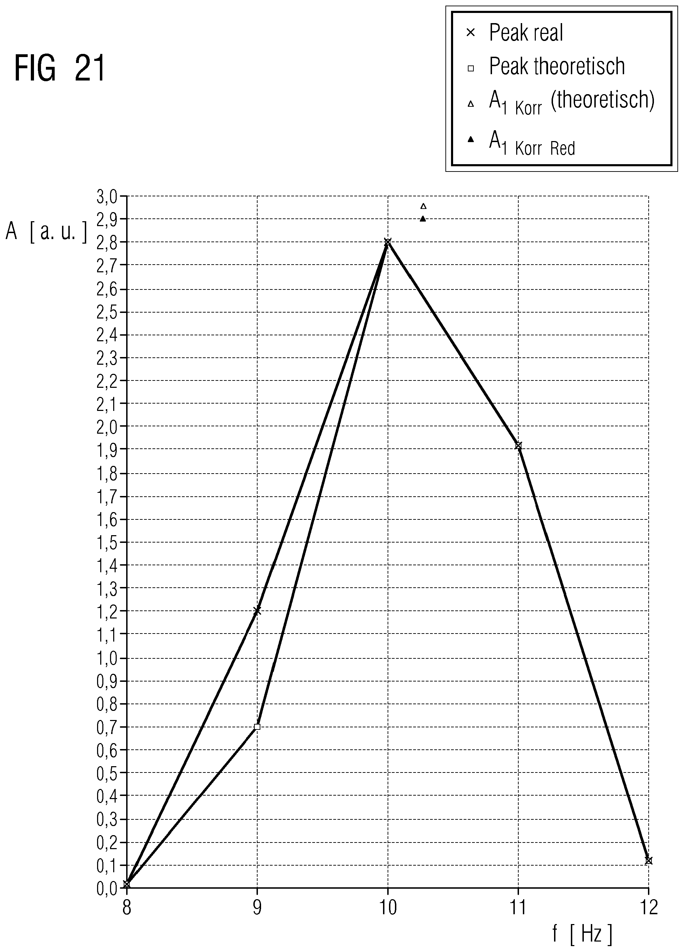

Vorliegend wird davon ausgegangen, dass aufgrund von nicht sinusförmigen Komponenten bzw. Rauschen in dem Spektrum eines real gemessenen Signals die Amplitude $A_3$ der dritthöchsten Spektrallinie $S_3$ höher ist, also theoretisch erwartet. Dies ist in Figur 21 dargestellt, welche neben dem Spektrum des bisher als Beispiel betrachteten rein sinusförmigen Signals der Frequenz von 10,27 Hz und der Amplitude von 2,97 das Spektrum des real gemessenen Signals aufweist. Die Spektrallinien des realen Signals sind schematisch als Kreuze dargestellt, die wiederum allein zur besseren Darstellung mit Linien verbunden sind, obwohl keine den Linien entsprechenden Zwischenwerte existieren.

Konkret beträgt die Amplitude $A_3$ in dem Spektrum des realen Signals mit Störanteilen nicht 0,73 sondern 1,20.

Der Abstand zwischen der Amplitude $A_2$ zweithöchsten und der Amplitude $A_3$ der dritthöchsten Spektrallinie beträgt somit

$Ist_{2-3}$ = 0,7 und

$Soll_{2-3}$ = 1,14.

Die sich hieraus ergebenden Werte sind in den folgenden Tabellen zusammen mit den bereits diskutierten Werten dargestellt:

| A$_1$ | A$_2$ | A$_3$ | Avg$_{12}$ | A$_1$/Avg$_{12}$ | MaxIsRight | n/N |
|---|---|---|---|---|---|---|
| 2,82 | 1,90 | 1,20 | 2,36 | 1,19 | FALSCH | 0,26 |

| A$_{1korrMax}$/Avg$_{12}$ bzw. A$_{1soll}$/Avg$_{12}$ | A$_{1korrMax}$ bzw. A$_{1soll}$ | Ist$_{2-3}$ | Soll$_{2-3}$ | ΔA$_{1korrMax}$ | ΔA$_{1korrRed}$ | A$_{1korrRed}$ |
|---|---|---|---|---|---|---|
| 1,26 | 2, 98 | 0,70 | 1,14 | 0,158 | 0,097 | 2,92 |

Die Werte A$_{1Korr}$ und A$_{1KorrRed}$ sind ebenfalls in dem Graphen in Figur 21 eingetragen und zwar in Form eines gefüllten Dreiecks (A$_{1KorrRed}$) und eines nicht gefüllten Dreiecks (A$_{1Korr}$). Wie man sieht, liegt die weiter korrigierte Amplitude A$_{1KorrRed}$ unterhalb der korrigierten Amplitude A$_{1Korr}$.

Im Anschluss wird das Verhältnis aus der für die vorliegende Fensterfunktion aus Figur 1 theoretisch maximal auftretenden Korrektur und der reduzierten Korrektur ermittelt und in % als Qualitätswert angegeben.

$$\text{Quality} = \Delta A_{1korrRed}/\Delta A_{1korrMax}$$

Für das obige Beispiel ergibt sich für die Qualität

$$\text{Quality} = 0,035/0,06 = 62 \%.$$

Auf diese Weise kann ein Maß ermittelt werden, dass dem Grad der Übereinstimmung der Annahmen und der realen Situation, in welcher Messfehler, Rauschen und Überlagerungen durch weitere Signalformen auftreten können, wiedergibt.

Abschließend erfolgt eine Plausibilitätsprüfung, im Rahmen derer überprüft wird, ob der Korrekturwert ΔA$_{1korrRed}$ zum einen nicht negativ ist und zum anderen nicht größer ist als das A$_1$* (Max (A$_{1soll}$/A$_1$) -1). Dadurch wird sichergestellt, dass die Korrektur nie die theoretisch auftretenden Grenzen überschreitet.

Im Folgenden wird das erfindungsgemäße Verfahren anhand zwei weiterer Beispiele von realen, zu analysierenden Signalen erläutert.

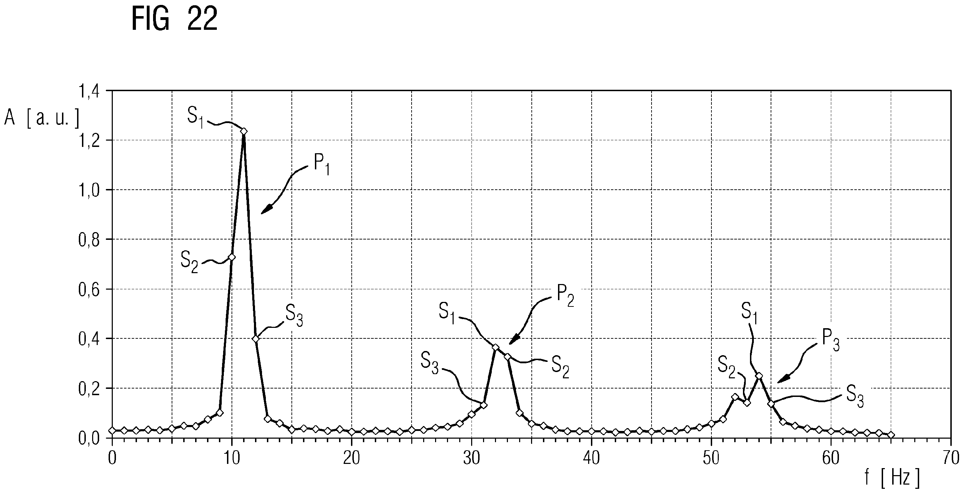

In Figur 22 ist das Spektrum eines Rechtecksignales dargestellt, welches Signalkomponenten unbekannter Frequenz und Amplitude umfasst. Das in Figur 21 dargestellte Spektrum wurde erhalten, indem das zeitabhängig erfasste Rechtecksignal mit der in Figur 1 dargestellten Hamming-Fensterfunktion multipliziert und einer schnellen Fourier-Transformation unterzogen wurde.

Wie der Figur 22 entnommen werden kann, welche einen Frequenzbereich von 0 bis 70 Hz zeigt, weist das Spektrum des Rechtecksignales drei Peaks P1, P2, P3 auf. Der linke Peak P1 liegt bei 11 Hz, der mittlere Peak P2 bei 32 Hz und der rechte Peak P3 bei 54 Hz.

Für jeden der drei Peaks P1, P2, P3 wird die höchste Spektrallinie S$_1$, die zu dieser benachbarte zweithöchste Spektrallinie S$_2$ und die zu der höchsten Spektrallinie S$_1$ benachbarte dritthöchste Spektrallinie S$_3$ ermittelt und die zugehörigen Amplituden A1, A$_2$ und A$_3$ werden bestimmt.

Die entsprechenden Werte sind in der folgenden Tabelle enthalten:

| | f$_1$ | A$_1$ | A$_2$ | A$_3$ | Avg$_{12}$ | A$_1$/ Avg$_{12}$ | MaxIs Right | n/N |
|---|---|---|---|---|---|---|---|---|
| P1 | 11 | 1,24 | 0,73 | 0,39 | 0, 98 | 1,26 | WAHR | -0,18 |
| P2 | 32 | 0,365 | 0,33 | 0,133 | 0,35 | 1,05 | FALSCH | 0,44 |
| P3 | 54 | 0,254 | 0,145 | 0,138 | 0,20 | 1,27 | WAHR | -0,16 |

| f$_{1korr}$ | A$_{1korrMax}$/Avg$_{12}$ bzw. A$_{1soll}$/Avg$_{12}$ | A$_{1korrMax}$ bzw. A$_{1soll}$ | IST$_{2-3}$ | SOLL$_{2-3}$ |
|---|---|---|---|---|
| 10,82 | 1,29 | 1,27 | 0,34 | 0,34 |
| 32,44 | 1,22 | 0,43 | 0,20 | 0,28 |

(fortgesetzt)

| $f_{1korr}$ | $A_{1korrMax}/Avg_{12}$ bzw. $A_{1soll}/Avg_{12}$ | $A_{1korrMax}$ bzw. $A_{1soll}$ | $IST_{2-3}$ | $SOLL_{2-3}$ |
|---|---|---|---|---|
| 53,84 | 1,30 | 0,26 | 0,01 | 0,06 |

| $\triangle A_{1korrMax}$ | $\triangle A_{1korrRed}$ | $A_{1korrRed}$ | Quality |
|---|---|---|---|
| 0,035 | 0, 035 | 1,27 | 99% |
| 0,060 | 0,043 | 0,41 | 71% |
| 0,006 | 0,001 | 0,25 | 11% |

Unter Heranziehung der vorstehend im Einzelnen diskutierten Kennlinien wird für die jeweils höchste Spektrallinie der drei lokalen Maxima erfindungsgemäß eine korrigierte Frequenz $f_{1korr}$ sowie eine korrigierte Amplitude $A_{1korrMax}$ bzw. $A_{1Soll}$ berechnet. Darüber hinaus wird die korrigierte Amplitude für jede der drei höchsten Spektrallinien erfindungsgemäß auf die vorstehend beschriebene Weise zu $A_{1korrRed}$ reduziert und es wird ein Qualitätswert ermittelt. Die entsprechenden Werte können der Tabelle entnommen werden.

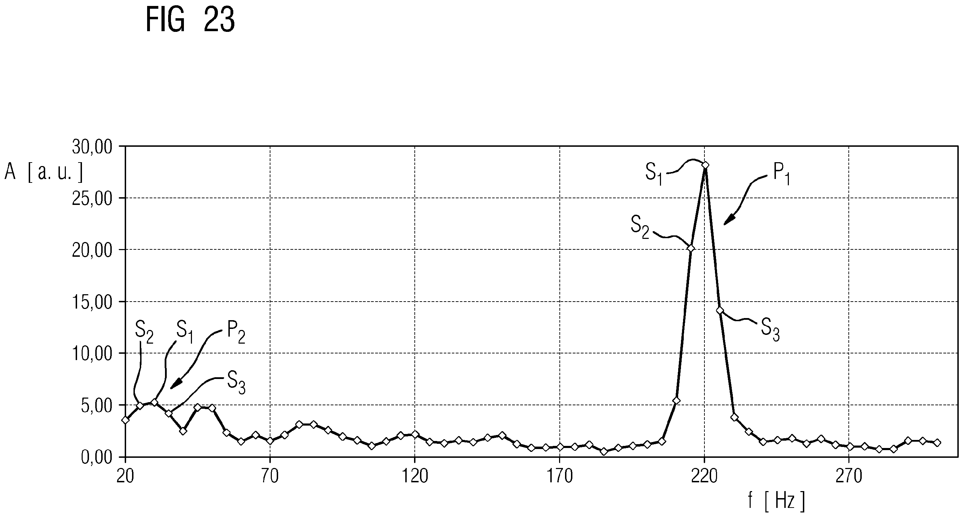

In der Figur 23 ist das Spektrum eines weiteren zu analysierenden, zeitabhängig erfassten Signals dargestellt. Bei dem zu analysierenden Signal handelt es sich um ein Drucksignal einer Verbrennungsschwingung, welches im Rahmen des Condition-Monitoring einer in den Figuren nicht dargestellten Gasturbine erfasst wurde.

Für die Durchführung des erfindungsgemäßen Verfahrens zur Analyse des Drucksignals der Gasturbine kommt eine in den Figuren ebenfalls nicht dargestellte Vorrichtung zum Einsatz, welche einen im Brennraum der Gasturbine vorgesehenen Sensor zur zeitabhängigen Erfassung des zu analysierenden Signals sowie eine mit dem Sensor verbundene Datenerfassungs- und - auswerteeinrichtung aufweist.

Bei dem Drucksensor handelt es sich vorliegend um einen Wechseldruckaufnehmer, mit dem während des Betriebes der Gasturbine Druckschwingungen in dem Brennraum messtechnisch erfasst werden.

Die Datenerfassungs- und -auswerteeinrichtung ist ausgebildet, um das mit dem Sensor aufgenommene Signal zeitabhängig zu erfassen, zu filtern und zu digitalisieren, sowie das Signal mit der vorgegebenen Fensterfunktion aus Figur 1 zu multiplizieren.

Sie ist ferner ausgebildet, um das erfasste Signal einer schnellen Fourier-Transformation zu unterwerfen, um ein Spektrum des Signals zu erhalten.

Darüber hinaus ist die Datenerfassungs- und auswerteeinrichtung ausgebildet und eingerichtet, um das erfindungsgemäße Verfahren zur Analyse des mit dem Sensor erfassten Signals durchzuführen.

Hierfür sind die Frequenz-Korrektur-Kennlinie, die Amplituden-Korrektur-Kennlinie und die weitere Amplituden-Korrektur-Kennlinie für die in Figur 1 dargestellte Fensterfunktion, deren Erstellung zuvor detailliert beschrieben wurde, in der Datenerfassungs- und auswerteeinrichtung der Vorrichtung abgelegt.

Das in Figur 23 dargestellte Spektrum des Drucksignals wurde analog zu den bereits diskutierten Beispielen erhalten, indem das mit dem Sensor der Vorrichtung im Betrieb der Gasturbine Drucksignal unter Verwendung der Datenerfassungs- und - auswerteeinrichtung der Vorrichtung mit der in Figur 1 dargestellten Hamming-Fensterfunktion multipliziert und einer schnellen Fourier-Transformation unterworfen wurde.

In der Figur 23 ist der Frequenzbereich von 20 Hz bis 300 Hz gezeigt. Ausgewertet werden im Rahmen des vorliegenden Ausführungsbeispiels mittels der Datenerfassungs- und auswerteeinrichtung der größte Peak P1 bei einer Frequenz von 220 Hz und der nächstkleinere Peak P2 bei einer Frequenz von 30 Hz. Dabei werden die in der folgenden Tabelle enthaltenen Werte erhalten:

| | $f_1$ | $\triangle f$ | $A_1$ | $A_2$ | $A_3$ | $Avg_{12}$ |
|---|---|---|---|---|---|---|
| **P1** | 220 | 5 | 28,27 | 20,18 | 14,20 | 24,23 |
| **P2** | 30 | 5 | 5,27 | 4,93 | 4,23 | 5,10 |

| $A_1/Avg_{12}$ | MaxIs Right | n/N | $f_{1korr}$ | $A_{1korrMax}/Avg_{12}$ bzw. $A_{1soll}/Avg_{12}$ |
|---|---|---|---|---|
| 1,17 | WAHR | -0,29 | 218,53 | 1,25 |
| 1,03 | WAHR | -0,46 | 27,69 | 1,22 |

| A$_{1korrMax}$ bzw. A$_{1soll}$ | IST$_{2-3}$ | SOLL$_{2-3}$ | $\triangle$A$_{1korrMax}$ | $\triangle$A$_{1korrRe}$ d | A$_{1korrRed}$ | Quality |
|---|---|---|---|---|---|---|
| 30,30 | 5,98 | 13,14 | 2,029 | 0,923 | 29,19 | 46% |
| 6,23 | 0,70 | 4,24 | 0,961 | 0,159 | 5,43 | 17% |

Unter Anwendung des erfindungsgemäßen Verfahrens wird für sämtliche der vorstehend diskutierten zu analysierenden zeitabhängig erfassten Beispielsignale die Frequenz und die Amplitude einer oder mehrere Signalkomponenten besonders zuverlässig unter vergleichsweise geringem Rechenaufwand bestimmt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zur Analyse eines Signals, bei dem

   - ein Spektrum des zu analysierenden Signals bereitgestellt wird, welches das Ergebnis einer Multiplikation des zu analysierenden Signals mit einer vorgegebenen Fensterfunktion und anschließenden insbesondere diskreten oder schnellen Fourier-Transformation ist das Verfahren ist **dadurch gekennzeichnet, dass**
   - in dem Spektrum im Bereich zumindest eines peakförmigen lokalen Maximums die bezüglich ihrer Amplitude höchste Spektrallinie (S$_1$) und die zu dieser unmittelbar benachbarte, bezüglich ihrer Amplitude zweithöchste Spektrallinie (S$_2$) des lokalen Maximums ermittelt wird,
   - die Amplitude (A$_1$) der höchsten Spektrallinie und die Amplitude (A$_2$) der zu dieser unmittelbar benachbarten zweithöchsten Spektrallinie bestimmt wird,
   - wenigstens ein von der Amplitude (A$_1$) der höchsten Spektrallinie (S$_1$) und der Amplitude (A$_2$) der zweithöchsten Spektrallinie (S$_2$) abhängiger Wert, insbesondere das Verhältnis der Amplitude (A$_1$) der höchsten Spektrallinie zu der Amplitude (A$_2$) der zweithöchsten Spektrallinie und/oder das Verhältnis der Amplitude (A$_1$) der höchsten Spektrallinie zu dem Mittelwert (Avg$_{12}$) aus den Amplituden (A$_1$, A$_2$) der höchsten und der zweithöchsten Spektrallinie ermittelt wird,
   - aus dem ermittelten Wert, insbesondere Verhältnis unter Heranziehung einer Frequenz-Korrektur-Kennlinie, welche für die vorgegebene Fensterfunktion erstellt wurde, ein Frequenz-Korrekturwert für die Frequenz der höchsten Spektrallinie (S$_1$) ermittelt wird, und
   - die Frequenz der höchsten Spektrallinie (S$_1$) um den Frequenz-Korrekturwert korrigiert wird.

2. Verfahren nach Anspruch 1, **dadurch gekennzeichnet, dass**

   - in dem Spektrum im Bereich mehrerer lokaler Maxima, insbesondere im Bereich aller lokaler Maxima jeweils die höchste Spektrallinie (S$_1$) und die zu dieser unmittelbar benachbarte zweithöchste Spektrallinie (S$_2$) ermittelt wird,
   - für jedes lokale Maximum die Amplitude (A$_1$) der höchsten Spektrallinie (S$_1$) und die Amplitude (A$_2$) der zweithöchsten Spektrallinie (S$_2$) bestimmt wird,
   - für jedes lokale Maximum wenigstens ein von der Amplitude (A$_1$) der höchsten Spektrallinie (S$_1$) und der Amplitude (A$_2$) der zweithöchsten Spektrallinie (S$_2$) abhängiger Wert, insbesondere das Verhältnis der Amplitude (A$_1$) der höchsten Spektrallinie (S$_1$) zu der Amplitude (A$_2$) der zweithöchsten Spektrallinie (S$_2$) und/oder das Verhältnis der Amplitude (A$_1$) der höchsten Spektrallinie (S$_1$) zu dem Mittelwert (Avg$_{12}$) aus den Amplituden (A$_1$, A$_2$) der höchsten und der zweithöchsten Spektrallinie (S$_1$, S$_2$) berechnet wird,
   - für jedes lokale Maximum aus dem berechneten Wert, insbesondere Verhältnis unter Heranziehung der Frequenz-Korrektur-Kennlinie ein Frequenz-Korrekturwert für die Frequenz der höchsten Spektrallinie (S$_1$) ermittelt wird, und
   - für jedes lokale Maximum die Frequenz der höchsten Spektrallinie (S$_1$) um den jeweiligen Frequenz-Korrekturwert korrigiert wird.

3. Verfahren nach einem der vorhergehenden Ansprüche, **dadurch gekennzeichnet, dass** eine Frequenz-Korrektur-Kennlinie herangezogen wird, welche für die vorgegebene Fensterfunktion unter Verwendung von zwei oder mehr insbesondere sinusförmigen Referenzsignalen unterschiedlicher Frequenz erstellt wurde.

**4.** Verfahren nach Anspruch 3, **dadurch gekennzeichnet, dass** eine Frequenz-Korrektur-Kennlinie für die vorgegebene Fensterfunktion erstellt wird, indem

- zwei oder mehr insbesondere sinusförmige Referenzsignale bereitgestellt werden,
- jedes Referenzsignal mit der Fensterfunktion multipliziert wird,
- jedes mit der Fensterfunktion multiplizierte Referenzsignal einer insbesondere diskreten oder schnellen Fourier-Transformation unterworfen werden,
- aus jedem transformierten Spektrum im Bereich eines lokalen Maximums jeweils die höchste Spektrallinie ($S_1$) und die zu dieser unmittelbar benachbarte zweithöchste Spektrallinie ($S_2$) ermittelt wird,
- für jedes transformierte Spektrum die Amplitude ($A_1$) der höchsten Spektrallinie ($S_1$) und die Amplitude ($A_2$) der zweithöchsten Spektrallinie ($S_2$) ermittelt wird,
- für jedes transformierte Spektrum wenigstens ein von der Amplitude ($A_1$) der höchsten Spektrallinie ($S_1$) und der Amplitude ($A_2$) der zweithöchsten Spektrallinie ($S_2$) abhängiger Wert, insbesondere das Verhältnis der Amplitude ($A_1$) der höchsten Spektrallinie ($S_1$) zu der Amplitude ($A_2$) der zweithöchsten Spektrallinie ($S_2$) und/oder das Verhältnis der Amplitude ($A_1$) der höchsten Spektrallinie ($S_1$) zu dem Mittelwert ($Avg_{12}$) aus den Amplituden ($A_1, A_2$) der höchsten und der zweithöchsten Spektrallinie ($S_1, S_2$) ermittelt wird,
- die ermittelten Werte, insbesondere Verhältnisse zusammen mit der zugehörigen Frequenz der Referenzsignale als Wertepaare abgelegt werden, und
- auf Basis der Wertepaare eine Kennlinie erstellt wird.

**5.** Verfahren nach Anspruch 4, **dadurch gekennzeichnet, dass** mehrere Referenzsignale bereitgestellt werden, indem

- ein insbesondere sinusförmiges Referenzsignal bekannter Frequenz bereitgestellt wird,
- das Referenzsignal zwischen der Frequenz einer beliebigen Spektrallinie ($f_{LinieL}$) und der Frequenz einer zu dieser benachbarten Spektrallinie ($f_{LinieL+1}$) variiert wird, um N weitere Referenzsignale mit den Frequenzen

$$f_n \;=\; f_{LinieL} \;+\; n/N \;*\; \Delta f$$

mit n = 0 ... N und der Auflösung $\Delta f$ zu erhalten.

**6.** Verfahren nach Anspruch 4 oder 5, **dadurch gekennzeichnet, dass** die aus den Spektren der Referenzsignale ermittelten von der Amplitude ($A_1$) der höchsten Spektrallinie ($S_1$) und der Amplitude ($A_2$) der zweithöchsten Spektrallinie ($S_2$) abhängigen Werte, insbesondere Verhältnisse der Amplitude ($A_1$) der höchsten Spektrallinie ($S_1$) zu der Amplitude ($A_2$) der zweihöchsten Spektrallinie ($S_2$) und/oder die Verhältnisse der Amplitude ($A_1$) der höchsten Spektrallinie ($S_1$) zu dem Mittelwert ($Avg_{12}$) aus den Amplituden ($A_1, A_2$) der höchsten und der zweithöchsten Spektrallinie ($S_1, S_2$) in einem Graphen gegen die variierte Frequenz ($f_n$) oder gegen das Verhältnis n/N oder gegen den Offset der Frequenzen n/N*$\Delta f$ aufgetragen werden.

**7.** Verfahren nach Anspruch 6, **dadurch gekennzeichnet, dass** an die in dem Graphen dargestellten Werte wenigstens eine Fit-Funktion (F1, F2) angelegt wird, insbesondere wenigstens eine lineare Fit-Funktion (F1, F2), wobei bevorzugt die wenigstens eine Fit-Funktion (F1, F2) als Frequenz-Korrektur-Kennlinie herangezogen wird.

**8.** Verfahren nach einem der vorhergehenden Ansprüche, **dadurch gekennzeichnet, dass** aus dem Frequenz-Korrekturwert oder der korrigierten Frequenz für die höchste Spektrallinie ($S_1$) im Bereich des wenigstens einen lokalen Maximums aus dem zu analysierenden Signal unter Heranziehung einer Amplituden-Korrektur-Kennlinie, welche insbesondere für die vorgegebene Fensterfunktion unter Verwendung von zwei oder mehr Referenzsignalen unterschiedlicher Frequenz erstellt wurde, ein Amplituden-Korrekturwert und/oder eine korrigierte Amplitude ermittelt wird.

**9.** Verfahren nach einem der Ansprüche 4 bis 7 und Anspruch 8, **dadurch gekennzeichnet, dass** die Amplituden-Korrektur-Kennlinie erstellt wird, indem aus dem Spektrum jedes Referenzsignals das Verhältnis eines vorgegebenen Sollwertes für die Amplitude ($A_{1soll}$) der höchsten Spektrallinie ($S_1$) zu dem Mittelwert ($Avg_{12}$) aus den Amplituden ($A_1, A_2$) der höchsten und der zweithöchsten Spektrallinie ($S_1, S_2$) ermittelt wird, und die ermittelten Verhältnisse zusammen mit der zugehörigen Frequenz der Referenzsignale als Wertepaare abgelegt werden, und auf Basis der Wertepaare eine Kennlinie erstellt wird.

10. Verfahren nach Anspruch 9, **dadurch gekennzeichnet, dass** die aus den Spektren der Referenzsignale ermittelten Verhältnisse in einem Graphen gegen die variierte Frequenz ($f_n$) oder gegen das Verhältnis n/N oder gegen den Offset der Frequenzen n/N*$\Delta$f aufgetragen werden und an die in dem Graphen dargestellten Werte eine Fit-Funktion (F5) angelegt wird, insbesondere eine Polynom-Fit-Funktion zweiten Grades, wobei bevorzugt die Fit-Funktion als Amplituden-Korrekturfunktion verwendet wird.

11. Verfahren nach Anspruch 9 oder 10, **dadurch gekennzeichnet, dass** aus den Spektren der Referenzsignale jeweils im Bereich desjenigen lokalen Maximums, in welchem die höchste und die zweithöchste Spektrallinie ($S_1$, $S_2$) ermittelt wurde, die zu der höchsten Spektrallinie ($S_1$) unmittelbar benachbarte dritthöchste Spektrallinie ($S_3$) und deren Amplitude ($A_3$) ermittelt wird, und der Abstand der Amplitude ($A_2$) der zweithöchsten Spektrallinie ($S_2$) zu der Amplitude ($A_3$) der dritthöchsten Spektrallinie ($S_3$) ermittelt wird.

12. Verfahren nach Anspruch 11, **dadurch gekennzeichnet, dass** die aus den Spektren der Referenzsignale ermittelten Abstände in einem Graphen gegen die variierte Frequenz ($f_n$) oder gegen das Verhältnis n/N oder gegen den Offset der Frequenz n/N*$\square$f aufgetragen werden, und an die in dem Graphen dargestellten Werte wenigstens eine insbesondere lineare Fit-Funktion (F8) angelegt wird und bevorzugt die Fit-Funktion (F8) als weitere Amplituden-Korrektur-Kennlinie verwendet wird.

13. Verfahren nach Anspruch 12, **dadurch gekennzeichnet, dass** in dem Spektrum des zu analysierenden Signals im Bereich desjenigen lokalen Maximums, in welchem die höchste und die zweithöchste Spektrallinie ($S_1$, $S_2$) ermittelt wurde, die zu der höchsten Spektrallinie ($S_1$) unmittelbar benachbarte dritthöchste Spektrallinie ($S_3$) und deren Amplitude ($A_3$) ermittelt wird, und der Abstand der Amplitude ($A_2$) der zweithöchsten Spektrallinie ($S_2$) von der Amplitude ($A_3$) der dritthöchsten Spektrallinie ($S_3$) als Abstands-Istwert ($Ist_{2\text{-}3}$) ermittelt wird.

14. Verfahren nach Anspruch 13, **dadurch gekennzeichnet, dass** aus der Fit-Funktion (F8) ein Abstands-Sollwert ($Soll_{A2\text{-}A3}$) für den Abstand von der Amplitude ($A_2$) der zweithöchsten Spektrallinie ($S_2$) zu der Amplitude ($A_3$) der dritthöchsten Spektrallinie ($S_3$) ermittelt und mit dem Abstands-Istwert ($Ist_{A2\text{-}A3}$) verglichen wird.

15. Verfahren nach Anspruch 14, **dadurch gekennzeichnet, dass** der Amplituden-Korrekturwert und/oder die korrigierte Amplitude in dem Maße reduziert wird, indem der Abstands-Istwert ($Ist_{A2\text{-}A3}$) von dem Abstands-Sollwert ($Soll_{A2\text{-}A3}$) abweicht.

16. Verfahren nach Anspruch 15, **dadurch gekennzeichnet, dass** das Verhältnis aus dem reduzierten Amplituden-Korrekturwert zu dem Amplituden-Korrekturwert und/oder das Verhältnis aus der reduzierten korrigierten Amplitude zu der korrigierten Amplitude gebildet und als Qualitätskriterium berücksichtigt wird.

17. Verfahren nach einem der Ansprüche 4 bis 16, **dadurch gekennzeichnet, dass** aus den Spektren der Referenzsignale das Verhältnis eines vorgegebenen Sollwertes ($A_{1soll}$) für die Amplitude der höchsten Spektrallinie ($S_1$) zu dem jeweiligen Istwert ($A_{1ist}$) der Amplitude der höchsten Spektrallinie ($S_1$) ermittelt wird, und die ermittelten Verhältnisse insbesondere in einem Graphen gegen die variierte Frequenz ($f_n$) oder gegen das Verhältnis n/N oder gegen den Offset der Frequenz n/N*$\square$f aufgetragen wird.

18. Verfahren nach Anspruch 17, **dadurch gekennzeichnet, dass** aus den Verhältnissen des vorgegebenen Sollwertes ($A_{1soll}$) der Amplitude der höchsten Spektrallinie ($S_1$)und dem jeweiligen Istwert der Amplitude ($A_{1ist}$) der höchsten Spektrallinie ($S_1$) der minimale und/oder der maximale Wert des Verhältnisses ermittelt wird, und der maximale Wert insbesondere als Plausibilitätskriterium herangezogen wird.

19. Verfahren nach einem der vorhergehenden Ansprüche, **dadurch gekennzeichnet, dass** das Referenzsignal in N = 10 Schritten, insbesondere in N = 20 Schritten, bevorzugt in N = 50 Schritten, besonders bevorzugt in N = 100 Schritten variiert wird.

20. Verfahren nach einem der vorhergehenden Ansprüche, **dadurch gekennzeichnet, dass** als Fensterfunktion eine Hamming-Fensterfunktion oder eine Tukey-Fensterfunktion oder eine Hanning-Fensterfunktion oder eine Rechteck-Fensterfunktion verwendet wird.

21. Vorrichtung für die Durchführung des Verfahrens zur Analyse eines Signals nach einem der vorhergehenden Ansprüche, umfassend eine Datenerfassungs- und -auswerteeinrichtung, welche ausgebildet ist, um

- mit wenigstens einem Sensor zur Aufnahme eines zu analysierenden Signals, insbesondere wenigstens einem Drucksensor und/oder wenigstens einem Schwingungssensor, verbunden zu werden,
- ein mit dem wenigstens einen Sensor aufgenommenes Signal zu erfassen und insbesondere zu filtern und/oder zu digitalisieren,
- das Signal mit einer vorgegebenen Fensterfunktion zu multiplizieren,
- das Signal einer insbesondere schnellen oder diskreten Fourier-Transformation zu unterwerfen, um ein Spektrum des Signals zu erhalten,

wobei die Datenerfassungs- und auswerteeinrichtung ausgebildet und eingerichtet ist, um das Verfahren nach einem der vorhergehenden Ansprüche zur Analyse eines mit dem wenigstens einen Sensor erfassten Signals durchzuführen.

22. Vorrichtung nach Anspruch 21, umfassend wenigstens einen Sensor zur Aufnahme eines zu analysierenden Signals, insbesondere wenigstens einen Drucksensor und/oder wenigstens einen Schwingungssensor, der mit der Datenerfassungs- und - auswerteeinrichtung verbunden ist.

**Claims**

1. Method for analysing a signal, in which

   - a spectrum of the signal to be analysed is provided, which is the result of a multiplication of the signal to be analysed by a predefined window function and subsequent, in particular discrete or fast, Fourier transformation, **characterized in that**
   - in the spectrum in the region of at least one peak-shaped local maximum, the highest spectral line ($S_1$) in terms of its amplitude and the second-highest spectral line ($S_2$) in terms of its amplitude that is directly adjacent thereto are determined for the local maximum,
   - the amplitude ($A_1$) of the highest spectral line and the amplitude ($A_2$) of the second-highest spectral line directly adjacent thereto are determined,
   - at least one value dependent on the amplitude ($A_1$) of the highest spectral line ($S_1$) and the amplitude ($A_2$) of the second-highest spectral line ($S_2$), in particular the ratio of the amplitude ($A_1$) of the highest spectral line to the amplitude ($A_2$) of the second-highest spectral line and/or the ratio of the amplitude ($A_1$) of the highest spectral line to the average value ($Avg_{12}$) of the amplitudes ($A_1$, $A_2$) of the highest and second-highest spectral lines, is determined,
   - a frequency correction value for the frequency of the highest spectral line ($S_1$) is determined from the determined value, in particular ratio, using a frequency correction characteristic curve which was created for the predefined window function, and
   - the frequency of the highest spectral line ($S_1$) is corrected by the frequency correction value.

2. Method according to Claim 1, **characterized in that**

   - in each case the highest spectral line ($S_1$) and the second-highest spectral line ($S_2$) directly adjacent thereto are determined in the spectrum in the region of a plurality of local maxima, in particular in the region of all local maxima,
   - the amplitude ($A_1$) of the highest spectral line ($S_1$) and the amplitude ($A_2$) of the second-highest spectral line ($S_2$) are determined for each local maximum,
   - at least one value dependent on the amplitude ($A_1$) of the highest spectral line ($S_1$) and the amplitude ($A_2$) of the second-highest spectral line ($S_2$), in particular the ratio of the amplitude ($A_1$) of the highest spectral line ($S_1$) to the amplitude ($A_2$) of the second-highest spectral line ($S_2$) and/or the ratio of the amplitude ($A_1$) of the highest spectral line ($S_1$) to the average value ($Avg_{12}$) of the amplitudes ($A_1$, $A_2$) of the highest and second-highest spectral lines ($S_1$, $S_2$), is calculated for each local maximum,
   - a frequency correction value for the frequency of the highest spectral line ($S_1$) is determined from the calculated value, in particular ratio, using the frequency correction characteristic curve for each local maximum, and
   - the frequency of the highest spectral line ($S_1$) is corrected by the respective frequency correction value for each local maximum.

3. Method according to either of the preceding claims, **characterized in that** a frequency correction characteristic curve is used which was created for the predefined window function using two or more, in particular sinusoidal, reference signals of different frequencies.

4. Method according to Claim 3, **characterized in that** a frequency correction characteristic curve is created for the predefined window function by a procedure in which

- two or more, in particular sinusoidal, reference signals are provided,
- each reference signal is multiplied by the window function,
- each reference signal multiplied by the window function is subjected to an in particular discrete or fast Fourier transformation,
- in each case the highest spectral line ($S_1$) and the second-highest spectral line ($S_2$) directly adjacent thereto are determined from each transformed spectrum in the region of a local maximum,
- the amplitude ($A_1$) of the highest spectral line ($S_1$) and the amplitude ($A_2$) of the second-highest spectral line ($S_2$) are determined for each transformed spectrum,
- at least one value dependent on the amplitude ($A_1$) of the highest spectral line ($S_1$) and the amplitude ($A_2$) of the second-highest spectral line ($S_2$), in particular the ratio of the amplitude ($A_1$) of the highest spectral line ($S_1$) to the amplitude ($A_2$) of the second-highest spectral line ($S_2$) and/or the ratio of the amplitude ($A_1$) of the highest spectral line ($S_1$) to the average value ($Avg_{12}$) of the amplitudes ($A_1$, $A_2$) of the highest and second-highest spectral lines ($S_1$, $S_2$), is determined for each transformed spectrum,
- the determined values, in particular ratios, are stored together with the associated frequency of the reference signals as value pairs, and
- a characteristic curve is created on the basis of the value pairs.

5. Method according to Claim 4, **characterized in that** a plurality of reference signals are provided by a procedure in which

- an in particular sinusoidal reference signal of known frequency is provided,
- the reference signal is varied between the frequency of an arbitrary spectral line ($f_{lineL}$) and the frequency of a spectral line ($f_{lineL+1}$) adjacent thereto in order to obtain N further reference signals having the frequencies

$$f_n = f_{lineL} + n/N * \Delta f$$

where n = 0 ... N and with the resolution $\Delta f$.

6. Method according to Claim 4 or 5, **characterized in that** the values dependent on the amplitude ($A_1$) of the highest spectral line ($S_1$) and the amplitude ($A_2$) of the second-highest spectral line ($S_2$), said values being determined from the spectra of the reference signals, in particular ratios of the amplitude ($A_1$) of the highest spectral line ($S_1$) to the amplitude ($A_2$) of the second-highest spectral line ($S_2$) and/or the ratios of the amplitude ($A_1$) of the highest spectral line ($S_1$) to the average value ($Avg_{12}$) of the amplitudes ($A_1$, $A_2$) of the highest and second-highest spectral lines ($S_1$, $S_2$), are plotted in a graph against the varied frequency ($f_n$) or against the ratio n/N or against the offset of the frequencies n/N*$\Delta f$.

7. Method according to Claim 6, **characterized in that** at least one fit function (F1, F2), in particular at least one linear fit function (F1, F2), is applied to the values represented in the graph, wherein the at least one fit function (F1, F2) is preferably used as a frequency correction characteristic curve.

8. Method according to any of the preceding claims, **characterized in that** an amplitude correction value and/or a corrected amplitude are/is determined from the frequency correction value or the corrected frequency for the highest spectral line ($S_1$) in the region of the at least one local maximum from the signal to be analysed using an amplitude correction characteristic curve which was created in particular for the predefined window function using two or more reference signals of different frequencies.

9. Method according to any of Claims 4 to 7 and Claim 8, **characterized in that** the amplitude correction characteristic curve is created by a procedure in which the ratio of a predefined setpoint value for the amplitude ($A_{1setpoint}$) of the highest spectral line ($S_1$) to the average value ($Avg_{12}$) of the amplitudes ($A_1$, $A_2$) of the highest and second-highest spectral lines ($S_1$, $S_2$) is determined from the spectrum of each reference signal, and the determined ratios are stored together with the associated frequency of the reference signals as value pairs, and a characteristic curve is created on the basis of the value pairs.

10. Method according to Claim 9, **characterized in that** the ratios determined from the spectra of the reference signals are plotted in a graph against the varied frequency ($f_n$) or against the ratio n/N or against the offset of the frequencies n/N*$\Delta$f, and a fit function (F5) in particular a second degree polynomial fit function, is applied to the values represented in the graph, wherein the fit function is preferably used as an amplitude correction function.

11. Method according to Claim 9 or 10, **characterized in that** the third-highest spectral line ($S_3$) directly adjacent to the highest spectral line ($S_1$)and the amplitude ($A_3$) of said third-highest spectral line are determined from the spectra of the reference signals in each case in the region of that local maximum at which the highest and second-highest spectral lines ($S_1$, $S_2$) were determined, and the distance between the amplitude ($A_2$) of the second-highest spectral line ($S_2$) and the amplitude ($A_3$) of the third-highest spectral line ($S_3$) is determined.

12. Method according to Claim 11, **characterized in that** the distances determined from the spectra of the reference signals are plotted in a graph against the varied frequency ($f_n$) or against the ratio n/N or against the offset of the frequency n/N*f, and at least one, in particular linear, fit function (F8) is applied to the values represented in the graph, and the fit function (F8) is preferably used as a further amplitude correction characteristic curve.

13. Method according to Claim 12, **characterized in that** the third-highest spectral line ($S_3$) directly adjacent to the highest spectral line ($S_1$)and the amplitude ($A_3$) of said third-highest spectral line are determined in the spectrum of the signal to be analysed in the region of that local maximum at which the highest and second-highest spectral lines ($S_1$, $S_2$) were determined, and the distance between the amplitude ($A_2$) of the second-highest spectral line ($S_2$) and the amplitude ($A_3$) of the third-highest spectral line ($S_3$) is determined as an actual distance value ($Actual_{2-3}$) .

14. Method according to Claim 13, **characterized in that** a setpoint distance value ($Setpoint_{A2-A3}$) for the distance between the amplitude ($A_2$) of the second-highest spectral line ($S_2$) and the amplitude ($A_3$) of the third-highest spectral line ($S_3$) is determined from the fit function (F8) and is compared with the actual distance value ($Actual_{A2-A3}$) .

15. Method according to Claim 14, **characterized in that** the amplitude correction value and/or the corrected amplitude are/is reduced to the extent to which the actual distance value ($Actual_{A2-A3}$) deviates from the setpoint distance value ($Setpoint_{A2-A3}$) .

16. Method according to Claim 15, **characterized in that** the ratio of the reduced amplitude correction value to the amplitude correction value and/or the ratio of the reduced corrected amplitude to the corrected amplitude are/is formed and taken into account as a quality criterion.

17. Method according to any of Claims 4 to 16, **characterized in that** the ratio of a predefined setpoint value ($A_{1setpoint}$) for the amplitude of the highest spectral line ($S_1$) to the respective actual value ($A_{1actual}$) of the amplitude of the highest spectral line ($S_1$) is determined from the spectra of the reference signals, and the determined ratios are plotted in particular in a graph against the varied frequency ($f_n$) or against the ratio n/N or against the offset of the frequency n/N*f.

18. Method according to Claim 17, **characterized in that**, from the ratios of the predefined setpoint value ($A_{1setpoint}$) of the amplitude of the highest spectral line ($S_1$) and the respective actual value of the amplitude ($A_{1actual}$) of the highest spectral line ($S_1$), the minimum value and/or the maximum value of the ratio are/is determined, and the maximum value is used in particular as a plausibility criterion.

19. Method according to any of the preceding claims, **characterized in that** the reference signal is varied in N = 10 steps, in particular in N = 20 steps, preferably in N = 50 steps, particularly preferably in N = 100 steps.

20. Method according to any of the preceding claims, **characterized in that** a Hamming window function or a Tukey window function or a Hanning window function or a rectangular window function is used as the window function.

21. Apparatus for carrying out the method for analysing a signal according to any of the preceding claims, comprising a data acquisition and evaluation device designed

- to be connected to at least one sensor for recording a signal to be analysed, in particular at least one pressure sensor and/or at least one vibration sensor,

- to acquire and in particular to filter and/or to digitize a signal recorded by the at least one sensor,
- to multiply the signal by a predefined window function,
- to subject the signal to an in particular fast or discrete Fourier transformation in order to obtain a spectrum of the signal,

wherein the data acquisition and evaluation device is designed and configured to carry out the method according to any of the preceding claims for analysing a signal acquired by the at least one sensor.

22. Apparatus according to Claim 21, comprising at least one sensor for recording a signal to be analysed, in particular at least one pressure sensor and/or at least one vibration sensor, which is connected to the data acquisition and evaluation device.

**Revendications**

1. Procédé d'analyse d'un signal, dans lequel

   - on se procure un spectre du signal à analyser, qui est le résultat d'une multiplication du signal à analyser par une fonction fenêtre donnée à l'avance et d'une transformation de Fourier, notamment discrète ou rapide, venant ensuite, le procédé étant **caractérisé en ce que**
   - on détermine dans le spectre, dans la région d'au moins un maximum local en forme de crête, la raie ($S_1$) spectrale la plus haute en ce qui concerne son amplitude et la raie ($S_2$) spectrale, qui en est voisine immédiatement et qui est la deuxième la plus haute en ce qui concerne son amplitude, du maximum local,
   - on détermine l'amplitude ($A_1$) de la raie spectrale la plus haute et l'amplitude ($A_2$) de la raie spectrale, qui en est voisine immédiatement et qui est la deuxième plus haute,
   - on détermine au moins une valeur, qui dépend de l'amplitude ($A_1$) de la raie ($S_1$) spectrale la plus haute et de l'amplitude ($A_2$) de la raie ($S_2$) spectrale la deuxième la plus haute, notamment le rapport de l'amplitude ($A_1$) de la raie spectrale la plus haute à l'amplitude ($A_2$) de la raie spectrale la deuxième la plus haute et/ou le rapport de l'amplitude ($A_1$) de la raie spectrale la plus haute à la valeur ($Avg_{12}$) moyenne de l'amplitude ($A_1$) de la raie spectrale la plus haute et de l'amplitude ($A_2$) de la raie spectrale la deuxième la plus haute,
   - à partir de la valeur déterminée, notamment à partir du rapport en tirant parti d'une courbe caractéristique de correction de fréquence, qui a été établie pour la fonction fenêtre donnée à l'avance, on détermine la valeur de correction de la fréquence pour la fréquence de la raie ($S_1$) spectrale la plus haute, et
   - on corrige la fréquence de la raie ($S_1$) spectrale la plus haute de la valeur de correction de la fréquence.

2. Procédé suivant la revendication 1, **caractérisé en ce que**

   - l'on détermine dans le spectre, dans la région de plusieurs maximum locaux, notamment dans la région de tous les maximum locaux, respectivement, la raie ($S_1$) spectrale la plus haute et la raie ($S_2$) spectrale, qui en est voisine immédiatement et qui est la deuxième la plus haute,
   - pour chaque maximum local, on détermine l'amplitude ($A_1$) de la raie ($S_1$) spectrale la plus haute et l'amplitude ($A_2$) de la raie ($S_2$) spectrale la deuxième la plus haute,
   - pour chaque maximum local, on calcule au moins une valeur, qui dépend de l'amplitude ($A_1$) de la raie ($S_1$) spectrale la plus haute et de l'amplitude ($A_2$) de la raie ($S_2$) spectrale la deuxième la plus haute, notamment le rapport de l'amplitude ($A_1$) de la raie ($S_1$) spectrale la plus haute à l'amplitude ($A_2$) de la raie ($S_2$) spectrale la deuxième la plus haute et/ou le rapport de l'amplitude ($A_1$) de la raie ($S_1$) spectrale la plus haute à la valeur ($Avg_{12}$) moyenne de l'amplitude ($A_1$) de la raie ($S_1$) spectrale la plus haute et de l'amplitude ($A_2$) de la raie ($S_2$) spectrale la deuxième la plus haute,
   - pour chaque maximum local, on détermine, à partir de la valeur calculée, notamment à partir du rapport et en tirant parti de la ligne caractéristique de correction de la fréquence, une valeur de correction de la fréquence pour la fréquence de la raie ($S_1$) spectrale la plus haute, et
   - pour chaque maximum local, on corrige la fréquence de la raie ($S_1$) spectrale la plus haute de la valeur de correction de la fréquence respective.

3. Procédé suivant l'une des revendications précédentes, **caractérisé en ce que** l'on tire parti d'une courbe caractéristique de correction de la fréquence, qui a été établie pour la fonction fenêtre donnée à l'avance, en utilisant deux ou plusieurs signaux de référence, notamment sinusoïdaux, de fréquence différente.

**4.** Procédé suivant la revendication 3, **caractérisé en ce que** l'on établit une courbe caractéristique de correction de la fréquence pour la fonction fenêtre donnée à l'avance, en

- se procurant deux ou plusieurs signaux de référence, notamment sinusoïdaux,
- multipliant chaque signal de référence par la fonction fenêtre,
- soumettant chaque signal de référence multiplié par la fonction de référence à une transformation de Fourrier, notamment discrète ou rapide,
- en déterminant, à partir de chaque spectre transformé dans la région d'un maximum local, respectivement, la raie ($S_1$) spectrale la plus haute et la raie ($S_2$) spectrale, qui en est voisine immédiatement et qui est la deuxième plus haute,
- pour chaque spectre transformé, on détermine l'amplitude ($A_1$) de la raie ($S_1$) spectrale la plus haute et l'amplitude ($A_2$) de la raie ($S_2$) spectrale la deuxième la plus haute,
- pour chaque spectre transformé, on détermine au moins une valeur, qui dépend de l'amplitude ($A_1$) de la raie ($S_1$) spectrale la plus haute et de l'amplitude ($A_2$) de la raie ($S_2$) spectrale la deuxième plus haute, notamment le rapport de l'amplitude ($A_1$) de la raie spectrale la plus haute à l'amplitude ($A_2$) de la raie spectrale la deuxième la plus haute et/ou le rapport de l'amplitude ($A_1$) de la raie spectrale la plus haute à la valeur ($Avg_{12}$) moyenne de l'amplitude ($A_1$) de la raie ($S_1$) spectrale la plus haute et de l'amplitude ($A_2$) de la raie ($S_2$) spectrale la deuxième la plus haute,
- on archive les valeurs déterminées, notamment les rapports, ensemble avec la fréquence associée des signaux de référence, sous la forme d'une paire de valeurs, et
- on établit une courbe caractéristique sur la base des paires de valeurs.

**5.** Procédé suivant la revendication 4, **caractérisé en ce que** l'on se procure plusieurs signaux de référence, en

- se procurant un signal de référence, notamment sinusoïdal, de fréquence connue,
- faisant varier le signal de référence entre la fréquence d'une raie ($f_{LinieL}$) spectrale quelconque et la fréquence d'une raie ($f_{Liniel+1}$) spectrale, qui en est voisine, pour obtenir N autres signaux de référence ayant les fréquences

$$f_n = ( f_{LinieL} ) + n/N * \Delta f$$

avec n = 0 ... N et la résolution $\Delta f$.

**6.** Procédé suivant la revendication 4 ou 5, **caractérisé en ce que** l'on porte les valeurs, déterminées à partir des spectres des signaux de référence, qui dépendent de l'amplitude ($A_1$), de la raie ($S_1$) spectrale la plus haute et de l'amplitude ($A_2$) de la raie ($S_2$) spectrale la deuxième la plus haute, notamment les rapport de l'amplitude ($A_1$) de la raie ($S_1$) spectrale la plus haute à l'amplitude ($A_2$) de la raie ($S_2$) spectrale la deuxième la plus haute et/ou les rapports de l'amplitude ($A_1$) de la raie ($S_1$) spectrale la plus haute à la valeur ($Avg_{12}$) moyenne de l'amplitude ($A_1$) de la raie ($S_1$) spectrale la plus haute et de l'amplitude ($A_2$) de la raie ($S_2$) spectrale la deuxième la plus haute dans un graphique, en fonction de la fréquence ($f_n$), qui varie, ou en fonction du rapport n/N ou en fonction du décalage des fréquences n/N*$\Delta f$.

**7.** Procédé suivant la revendication 6, **caractérisé en ce que** l'on met, sur les valeurs représentées dans le graphique, au moins une fonction (F1, F2) d'ajustement, notamment au moins une fonction (F1, F2) d'ajustement linéaire, dans lequel on tire parti, de préférence, de la fonction (F1, F2) d'ajustement comme courbe caractéristique de correction de la fréquence.

**8.** Procédé suivant l'une des revendications précédentes, **caractérisé en ce que** l'on détermine une valeur de correction d'amplitude et/ou une amplitude corrigée à partir de la valeur de correction de la fréquence ou de la fréquence corrigée, pour la raie ($S_1$) spectrale la plus haute dans la région du au moins un maximum local, à partir du signal à analyser, en tirant parti d'une courbe caractéristique de correction de l'amplitude, qui a été établie, notamment pour la fonction de fenêtre donnée à l'avance, en utilisant deux ou plusieurs signaux de référence de fréquence différente.

**9.** Procédé suivant l'une des revendications 4 à 7 et la revendication 8, **caractérisé en ce que** l'on établit la courbe caractéristique de correction de l'amplitude en déterminant, à partir du spectre de chaque signal de référence, le rapport d'une valeur de consigne donnée à l'avance de l'amplitude ($A_{1soll}$) de la raie ($S_1$) spectrale la plus haute à

la valeur ($Avg_{12}$) moyenne de l'amplitude ($A_1$) de la raie ($S_1$) spectrale la plus haute et de l'amplitude ($A_2$) de la raie ($S_2$) spectrale la deuxième la plus haute, et en archivant, comme paires de valeurs, les rapports déterminés ensemble avec la fréquence associée des signaux de référence, et on établit une courbe caractéristique sur la base des paires de valeurs.

10. Procédé suivant la revendication 9, **caractérisé en ce que** l'on porte les rapports, déterminés à partir des spectres des signaux de référence, dans un graphique, en fonction de la fréquence ($f_n$), qui varie, ou en fonction du rapport n/N ou en fonction du décalage des fréquences n/N*$\Delta$f et on applique, sur les valeurs représentées dans le graphique, une fonction (F5) d'ajustement, notamment une fonction d'ajustement polynôme du deuxième degré, en utilisant de préférence la fonction d'ajustement comme fonction de correction de l'amplitude.

11. Procédé suivant la revendication 9 ou 10, **caractérisé en ce que** l'on détermine, en fonction des spectres des signaux de référence, respectivement, dans la région du maximum local, où à été déterminée la raie ($S_1$) spectrale la plus haute et la raie ($S_2$) spectrale la deuxième la plus haute, la raie ($S_3$) spectrale, qui est voisine immédiatement de la raie ($S_1$) spectrale la plus haute et qui est la troisième la plus haute, et son amplitude ($A_3$), et on détermine la distance de l'amplitude ($A_2$) de la raie ($S_2$) spectrale la deuxième la plus haute à l'amplitude ($A_3$) de la raie ($S_3$) spectrale la troisième la plus haute.

12. Procédé suivant la revendication 11, **caractérisé en ce que** l'on porte les distances déterminées à partir des spectres des signaux de référence dans un graphique, en fonction de la fréquence ($f_n$), qui varie, ou en fonction du rapport n/N ou en fonction du décalage de la fréquence n/N*$\square$f, et on applique, aux valeurs représentées dans le graphique, au moins une fonction (F8) d'ajustement, notamment linéaire, et on utilise de préférence la fonction (F8) d'ajustement comme autre courbe caractéristique de correction de l'amplitude.

13. Procédé suivant la revendication 12, **caractérisé en ce que** l'on détermine, dans le spectre du signal à analyser, dans la région du maximum local où a été déterminée la raie ($S_1$) spectrale la plus haute et la raie ($S_2$) spectrale la deuxième la plus haute, la raie ($S_3$) spectrale, qui est voisine immédiatement de la raie ($S1$) spectrale la plus haute et qui est la troisième la plus haute et son amplitude ($A_3$), et on détermine, comme valeur ($Ist_{2-3}$) réelle de distance, la distance de l'amplitude ($A_2$) de la raie ($S_2$) spectrale la deuxième la plus haute à l'amplitude ($A_3$) de la raie ($S_3$) spectrale la troisième la plus haute.

14. Procédé suivant la revendication 13, **caractérisé en ce que** l'on détermine, à partir de la fonction (F8) d'ajustement, une valeur ($Soll_{A2-A3}$) de consigne de distance de la distance de l'amplitude ($A_2$) de la raie ($S_2$) spectrale la deuxième la plus haute à l'amplitude ($A_3$) de la raie ($S_3$) spectrale la troisième la plus haute et on la compare à la valeur ($Ist_{A2-A3}$) réelle de distance.

15. Procédé suivant la revendication 14, **caractérisé en ce que** l'on réduit la valeur de correction de l'amplitude et/ou l'amplitude corrigée dans la mesure où la valeur ($Ist_{A2-A3}$) réelle de distance s'écarte de la valeur ($Soll_{A2-A3}$) de consigne de distance.

16. Procédé suivant la revendication 15, **caractérisé en ce que** l'on forme le rapport de la valeur réduite de correction de l'amplitude à la valeur de correction de l'amplitude et/ou le rapport de l'amplitude corrigée réduite à l'amplitude corrigée et on en tient compte comme critère de qualité.

17. Procédé suivant l'une des revendications 4 à 16, **caractérisé en ce que** l'on détermine, à partir des spectres des signaux de référence, le rapport d'une valeur ($A_{1soll}$) de consigne donnée à l'avance de l'amplitude de la raie ($S_1$) spectrale la plus haute à la valeur ($A_{1ist}$) réelle respective de l'amplitude de la raie ($S_1$) spectrale la plus haute, et on porte les rapport déterminés, notamment dans un graphique, en fonction de la fréquence ($f_n$), qui varie, ou en fonction du rapport n/N ou en fonction du décalage n/N*$\square$f.

18. Procédé suivant la revendication 17, **caractérisé en ce que** l'on détermine, à partir des rapports de la valeur ($A_{1soll}$) de consigne donnée à l'avance de l'amplitude de la raie ($S_1$) spectrale la plus haute et de la valeur réelle respective de l'amplitude ($A_{1ist}$) de la raie ($S_1$) spectrale la plus haute, la valeur minimum et/ou la valeur maximum du rapport, et on tire parti de la valeur maximum, notamment comme critère de vraisemblance.

19. Procédé suivant l'une des revendications précédentes, **caractérisé en ce que** le signal de référence varie en N = 10 pas, notamment en N = 20 pas, de préférence en N = 50 pas, d'une manière particulière préférée en N = 100 pas.

**20.** Procédé suivant l'une des revendications précédentes, **caractérisé en ce que** l'on utilise, comme fonction de fenêtre, une fonction de fenêtre de Hamming ou une fonction de fenêtre de Tukey ou une fonction de fenêtre de Hanning ou une fonction de fenêtre rectangulaire.

**21.** Système pour effectuer le procédé d'analyse d'un signal suivant l'une des revendications précédentes, comprenant un dispositif de relevé et d'exploitation de données, qui est constitué pour

- être relié à au moins un capteur d'enregistrement d'un signal à analyser, notamment à au moins un capteur de pression et/ou à au moins un capteur d'oscillation,
- relever et notamment filtrer et/ou numériser un signal enregistré par le au moins un capteur,
- multiplier le signal par une fonction de fenêtre donnée à l'avance,
- soumettre le signal à une transformation de Fourier, notamment rapide ou discrète, pour obtenir un spectre du signal,

le dispositif de détection et d'exploitation de données étant constitué et conçu pour effectuer un procédé, suivant l'une des revendications précédentes, d'analyse d'un signal relevé par le au moins un capteur.

**22.** Système suivant la revendication 21, comprenant au moins un capteur d'enregistrement d'un signal à analyser, notamment au moins un capteur de pression et/ou au moins un capteur d'oscillation, qui est relié au dispositif de relevé et d'exploitations de données.

# FIG 1

FIG 2

FIG 3

FIG 4

FIG 5

A [ a. u. ]

t [ s ]

FIG 6

A [ a. u. ]

t [ s ]

FIG 7

A [ a. u. ]

$S_1$

$S_2$

$S_3$

f [ Hz ]

FIG 8

A [a. u. ]

t [ s ]

FIG 9

A [a. u. ]

t [ s ]

FIG 10

A [a. u. ]

$S_1$   $S_2$

$S_3$

f [ Hz ]

A [a.u.]

FIG 11

t [s]

A [a.u.]

FIG 12

t [s]

A [a.u.]

FIG 13

$S_1$

$S_2$

$S_3$

f [Hz]

FIG 14

A [a.u.]

FIG 15

A [a.u.]

FIG 16

A [a.u.]

FIG 17

FIG 18

# FIG 19

## FIG 20

Legend:
- $Soll_{2-3}$ (links)
- $Soll_{2-3}$ (rechts)
- Fit-Funktion (links)

Y-axis: $Soll_{2-3}$ — 0,00; 0,10; 0,20; 0,30; 0,40; 0,50; 0,60; 0,70; 0,80

X-axis: n / N — 0,0; 0,1; 0,2; 0,3; 0,4; 0,5; 0,6; 0,7; 0,8; 0,9; 1,0

$F_8$

FIG 21

FIG 22

FIG 23

EP 3 281 021 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2009231956 A1

- US 20090231956 A1